# FASCICULE DE BREVET EUROPEEN

(11) **EP 3 815 139 B1**
(45) Date de publication et mention de la délivrance du brevet: **29.03.2023**
(21) Numéro de dépôt: 19745709.6
(22) Date de dépôt: 24.06.2019
(51) Int. Cl.: H01L 25/16, H01L 27/15, H01L 33/50, H01L 33/62

(54) **DISPOSITIF OPTOELECTRONIQUE A DIODES ELECTROLUMINESCENTES**
OPTOELEKTRONISCHE VORRICHTUNG MIT LEUCHTDIODEN
OPTOELECTRONIC DEVICE COMPRISING LIGHT-EMITTING DIODES

(30) Priorité: 26.06.2018 FR 1855718
(43) Date de publication de la demande: 05.05.2021
(73) Titulaire: ALEDIA, 38130 Echirolles (FR)
(72) Inventeur: ROBIN, Ivan-Christophe, 38000 GRENOBLE (FR); DORNEL, Erwan, 38800 CHAMPAGNIER (FR); MERCIER, Frédéric, 38500 SAINT NICOLAS DE MACHERIN (FR)
(74) Mandataire: Cabinet Beaumont
(86) Numéro de dépôt international: PCT/FR2019/051547
(87) Numéro de publication internationale: WO 2020/002815

(56) Documents cités:
- EP-A1- 3 024 030
- WO-A1-2016/034388
- WO-A1-2017/217703
- US-A1- 2011 294 240
- US-A1- 2013 048 940
- US-A1- 2015 362 165
- US-A1- 2017 194 304

## Description

### Domaine

La présente demande concerne un dispositif optoélectronique, notamment un écran d'affichage ou un dispositif de projection d'images, comprenant des diodes électroluminescentes, à base de matériaux semiconducteurs, et leurs procédés de fabrication.

### Exposé de l'art antérieur

Un pixel d'une image correspond à l'élément unitaire de l'image affichée par le dispositif optoélectronique. Lorsque le dispositif optoélectronique est un écran d'affichage d'images couleur, il comprend en général pour l'affichage de chaque pixel de l'image au moins trois composants, également appelés sous-pixels d'affichage, qui émettent chacun un rayonnement lumineux sensiblement dans une seule couleur (par exemple, le rouge, le vert et le bleu). La superposition des rayonnements émis par ces trois sous-pixels d'affichage fournit à l'observateur la sensation colorée correspondant au pixel de l'image affichée. Dans ce cas, on appelle pixel d'affichage du dispositif optoélectronique l'ensemble formé par les trois sous-pixels d'affichage utilisés pour l'affichage d'un pixel d'une image.

Chaque sous-pixel d'affichage peut comprendre une source lumineuse, notamment une diode électroluminescente par exemple à base de matériaux semiconducteurs. Un procédé connu de fabrication d'un dispositif optoélectronique, notamment un écran d'affichage ou un dispositif de projection d'images, comprenant des diodes électroluminescentes, appelé procédé "pick and place", consiste à fabriquer les diodes électroluminescentes sous la forme de composants distincts, et à placer chaque diode électroluminescente à une position souhaitée sur un support qui peut comprendre des pistes conductrices pour la connexion électrique des diodes électroluminescentes.

Un inconvénient d'un tel procédé est qu'il nécessite généralement de placer avec précision les diodes électroluminescentes sur le support. Ceci nécessite la mise en oeuvre de procédés d'alignement d'autant plus complexes que les dimensions des diodes électroluminescentes sont réduites.

Un autre inconvénient d'un tel procédé est qu'une augmentation de la résolution du dispositif optoélectronique se traduit par une augmentation du nombre de transferts de diodes électroluminescentes sur le support et donc une augmentation de la durée de la fabrication du dispositif optoélectronique qui peut ne pas être compatible avec une fabrication à une échelle industrielle.

Pour la réalisation d'un grand écran à diodes électroluminescentes composé de diodes électroluminescentes unitaires assemblées, les diodes électroluminescentes doivent être assemblées avec des circuits de commande qui contrôlent un certain nombre de diodes électroluminescentes. Les ensembles comprenant les circuits de commande et les diodes électroluminescentes sont alors reliés entre eux par des fils. Cet assemblage réduit la quantité de données pouvant être transmise et il peut être difficile d'afficher un flux vidéo.

Pour les écrans comprenant des diodes électroluminescentes de taille micrométrique, par exemple pour les formats type TV, tablette, téléphone intelligent (en anglais smart phone) qui sont en cours de développement par plusieurs industriels, une matrice active est nécessaire pour afficher un flux vidéo avec une haute résolution. Actuellement, les matrices actives pour les écrans sont réalisées avec des transistors en couches minces, ou TFT (sigle anglais pour Thin Film Transistor). Les TFT utilisent généralement des dépôts de silicium amorphe ou polycristallin sur de grandes surfaces de verre et nécessitent l'utilisation de procédés de microélectronique complexes sur de grandes surfaces.

EP3024030 divulgue un dispositif optoélectronique comprenant un circuit de pixel d'affichage comprenant des première et deuxième faces opposées, le circuit de pixel d'affichage comprenant un circuit électronique comprenant la première face et une troisième face opposée à la première face, et un circuit optoélectronique fixé à la troisième face et comprenant au moins deux diodes électroluminescentes, au moins l'une des électrodes de chaque diode électroluminescente étant connectée au circuit électronique par la troisième face, le circuit optoélectronique comprenant en outre des blocs photoluminescents recouvrant les diodes électroluminescentes et des murs, conducteurs électriquement, entourant les blocs photoluminescents.

WO2016/034388 divulgue un dispositif optoélectronique comprenant un circuit de pixel d'affichage comprenant des première et deuxième faces opposées, le circuit de pixel d'affichage comprenant un circuit électronique comprenant la première face et une troisième face opposée à la première face, et un circuit optoélectronique fixé à la troisième face et comprenant au moins deux diodes électroluminescentes, au moins l'une des électrodes de chaque diode électroluminescente étant connectée au circuit électronique par la troisième face, le circuit optoélectronique comprenant en outre des blocs photoluminescents recouvrant les diodes électroluminescentes et des murs semiconducteurs entourant les blocs photoluminescents, et une couche conductrice électriquement reliée électriquement au circuit de pixel d' affichage.

WO2017/217703 et US2017/0194304 divulguent chacun un dispositif optoélectronique comprenant plusieurs circuits de pixel d'affichage comprenant un circuit électronique et plusieurs diodes électroluminescentes connectées au circuit électronique, le dispositif optoélectronique comprenant des blocs photoluminescents recouvrant les diodes électroluminescentes et des murs isolants entourant les blocs photoluminescents, et une couche conductrice électriquement entre les diodes électroluminescentes et les blocs photoluminescents et reliée électriquement aux diodes électroluminescentes.

Il serait souhaitable de pouvoir réaliser des pixels d'affichage dits intelligents intégrant avec les diodes électroluminescentes, notamment de taille micrométrique, de l'électronique de commande de façon à réaliser des matrices actives sans TFT. Ces matrices actives pourraient être réalisées sur de très grandes surfaces car elles s'appuient sur des circuits électroniques embarqués sous le pixel. D'autre part ces circuits électroniques pourraient profiter des performances des technologies à base de silicium.

### Résumé

Ainsi, un objet d'un mode de réalisation est de pallier au moins en partie les inconvénients des dispositifs optoélectroniques comprenant des diodes électroluminescentes décrits précédemment.

Un autre objet d'un mode de réalisation est de réduire le nombre de transferts de composants sur le support du dispositif optoélectronique lors de la fabrication du dispositif optoélectronique.

Un autre objet d'un mode de réalisation est de réduire les contraintes de précision lors du placement de composants sur le support du dispositif optoélectronique.

Un autre objet d'un mode de réalisation est que les dispositifs optoélectroniques puissent être fabriqués à une échelle industrielle et à bas coût.

Un autre objet d'un mode de réalisation est que le dispositif optoélectronique comprend une matrice active sans TFT.

Ainsi, un mode de réalisation prévoit un dispositif optoélectronique comprenant :
un support ;
au moins une première couche conductrice électriquement recouvrant le support ;
des circuits de pixel d'affichage comprenant des première et deuxième faces opposées, fixés à la première couche conductrice électriquement, chaque circuit de pixel d'affichage comprenant un circuit électronique comprenant la première face et une troisième face opposée à la première face, la première face étant fixée à la première couche conductrice électriquement, et un circuit optoélectronique fixé à la troisième face et comprenant au moins deux diodes électroluminescentes, au moins l'une des électrodes de chaque diode électroluminescente étant connectée au circuit électronique par la troisième face, le circuit optoélectronique comprenant en outre des blocs photoluminescents recouvrant les diodes électroluminescentes et des murs, conducteurs électriquement ou semiconducteurs, entourant les blocs photoluminescents ; et
au moins une deuxième couche conductrice électriquement reliée électriquement à au moins l'un des circuits de pixel d'affichage.

Selon un mode de réalisation, la deuxième couche conductrice électriquement recouvre au moins partiellement ledit au moins l'un des circuits de pixel d'affichage.

Selon un mode de réalisation, la deuxième couche conductrice électriquement est reliée électriquement aux murs dudit au moins l'un des circuits de pixel d'affichage.

Selon un mode de réalisation, la deuxième couche conductrice électriquement est, pour ledit au moins l'un des circuits de pixel d'affichage, au contact d'un plot conducteur électriquement du circuit électronique situé du côté de la troisième face.

Selon un mode de réalisation, la deuxième couche conductrice électriquement s'étend sur le support et la deuxième couche conductrice électriquement est, pour ledit au moins l'un des circuits de pixel d'affichage, au contact d'un plot conducteur électriquement du circuit électronique situé du côté de la première face.

Selon un mode de réalisation, le dispositif comprend en outre une première couche isolante électriquement recouvrant la première couche conductrice électriquement entre les circuits de pixel d'affichage et interposée entre la première couche isolante électriquement et la deuxième couche conductrice électriquement.

Selon un mode de réalisation, le dispositif comprend en outre, pour chaque circuit de pixel d'affichage, une deuxième couche isolante électriquement recouvrant les flancs du circuit de pixel d'affichage.

Selon un mode de réalisation, pour chaque circuit de pixel d'affichage, le circuit optoélectronique du circuit de pixel d'affichage comprend une première couche semiconductrice sur laquelle reposent les murs et les blocs photoluminescents et, pour chaque diode électroluminescente, un empilement reposant sur la première couche semiconductrice du côté opposé aux blocs photoluminescents et comprenant une deuxième couche semiconductrice dopée d'un premier type de conductivité, une couche active et une troisième couche semiconductrice dopée d'un deuxième type de conductivité opposé au premier type de conductivité, les empilements étant distincts.

Selon un mode de réalisation, chaque circuit de pixel d'affichage comprend, pour chaque empilement, un plot conducteur au contact de la première couche semiconductrice et fixé au circuit électronique du circuit de pixel d'affichage.

Selon un mode de réalisation, le dispositif comprend au moins deux premières couches conductrices électriquement disjointes et recouvrant le support, des circuits de pixel d'affichage parmi les circuits de pixel d'affichage étant fixés à chaque première couche conductrice électriquement, le dispositif comprenant, en outre, au moins deux deuxièmes couches conductrices électriquement chacune étant reliée électriquement à des circuits électroniques parmi les circuits de pixel d'affichage.

Selon un mode de réalisation, les deux premières couches conductrices électriquement et les deux deuxièmes couches conductrices électriquement ont la forme de bandes parallèles.

Un mode de réalisation prévoit également un procédé de fabrication d'un dispositif optoélectronique comprenant les étapes suivantes :
a) fabriquer des circuits de pixel d'affichage comprenant des première et deuxième faces opposées et comprenant chacun un circuit électronique comprenant la première face et une troisième face opposée à la première face, et un circuit optoélectronique fixé à la troisième face et comprenant au moins deux diodes électroluminescentes, au moins l'une des électrodes de chaque diode électroluminescente étant connectée au circuit électronique par la troisième face, le circuit optoélectronique comprenant en outre des blocs photoluminescents recouvrant les diodes électroluminescentes et des murs, conducteurs électriquement ou semiconducteurs, entourant les blocs photoluminescents ;
b) fabriquer un support recouvert d'au moins une première couche conductrice électriquement ;
c) fixer la première face du circuit électronique de chaque circuit de pixel d'affichage à la première couche conductrice électriquement ; et
d) former au moins une deuxième couche conductrice électriquement reliée électriquement à au moins l'un des circuits de pixel d'affichage.

Selon un mode de réalisation, la deuxième couche conductrice électriquement recouvre au moins partiellement ledit au moins l'un des circuits de pixel d'affichage.

Selon un mode de réalisation, la deuxième couche conductrice électriquement est reliée électriquement aux murs dudit au moins l'un des circuits de pixel d'affichage.

Selon un mode de réalisation, la deuxième couche conductrice électriquement est, pour ledit au moins l'un des circuits de pixel d'affichage, au contact d'un plot conducteur électriquement du circuit électronique situé du côté de la troisième face.

Selon un mode de réalisation, la deuxième couche conductrice électriquement s'étend sur le support et la deuxième couche conductrice électriquement est, pour ledit au moins l'un des circuits de pixel d'affichage, au contact d'un plot conducteur électriquement du circuit électronique situé du côté de la première face.

Selon un mode de réalisation, le procédé comprend, entre les étapes c) et d), l'étape de formation d'une première couche isolante électriquement recouvrant la première couche conductrice électriquement entre les circuits de pixel d'affichage et interposée entre la première couche isolante électriquement et la deuxième couche conductrice électriquement.

Selon un mode de réalisation, le procédé comprend, avant l'étape c), l'étape de formation, pour chaque circuit de pixel d'affichage, en outre, d'une deuxième couche isolante électriquement recouvrant les flancs du circuit de pixel d'affichage.

Selon un mode de réalisation, l'étape a) comprend la formation, pour chaque diode électroluminescente, d'un empilement reposant sur une première couche semiconductrice et comprenant une deuxième couche semiconductrice dopée d'un premier type de conductivité, une couche active et une troisième couche semiconductrice dopée d'un deuxième type de conductivité opposé au premier type de conductivité, les empilements étant distincts.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2 sont respectivement une vue en coupe latérale et une vue de dessus, partielles et schématiques, d'un mode de réalisation d'un dispositif optoélectronique ;
la figure 3 est une vue en coupe d'un autre mode de réalisation d'un dispositif optoélectronique ;
la figure 4A est un schéma électrique équivalent d'un pixel d'affichage du dispositif optoélectronique représenté sur les figures 1 et 3 ;
les figures 4B et 4C sont des schémas électriques analogues à la figure 4A incluant des modes de réalisation du circuit de commande du dispositif optoélectronique ;
la figure 5 est une vue de dessus, partielle et schématique, du dispositif optoélectronique représenté sur les figures 1 et 3 illustrant un avantage du procédé de fabrication du dispositif optoélectronique ;
la figure 6 est un schéma illustrant la commande du dispositif optoélectronique représenté sur les figures 1 ou 3 ;
les figures 7 à 11 sont des vues de dessus, partielles et schématiques, d'autres modes de réalisation d'un dispositif optoélectronique ;
les figures 12A à 12L sont des vues en coupe latérales, partielles et schématiques, de structures obtenues à des étapes successives d'un mode de réalisation d'un procédé de fabrication du dispositif optoélectronique représenté sur la figure 1 ;
les figures 13A à 13E sont des vues en coupe latérales, partielles et schématiques, de structures obtenues à des étapes successives d'un mode de réalisation d'un procédé de fabrication du dispositif optoélectronique représenté sur la figure 3 ;
la figure 14 est une vue en coupe de la structure obtenue à une étape d'un autre mode de réalisation d'un procédé de fabrication du dispositif optoélectronique représenté sur la figure 1 ou 3 ;
la figure 15 est une vue en coupe d'un autre mode de réalisation d'un dispositif optoélectronique ;
les figures 16A à 16K sont des vues en coupe latérales, partielles et schématiques, de structures obtenues à des étapes successives d'un mode de réalisation d'un procédé de fabrication du dispositif optoélectronique représenté sur la figure 15 ;
la figures 17 et 18A sont respectivement une vue en coupe et une vue de dessus, partielles et schématiques, d'un autre mode de réalisation d'un dispositif optoélectronique ;
la figure 18B est une variante de la figure 18A ; et
les figures 19A à 19J sont des vues en coupe latérales, partielles et schématiques, de structures obtenues à des étapes successives d'un mode de réalisation d'un procédé de fabrication du dispositif optoélectronique représenté sur les figures 17 et 18.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, la structure d'une diode électroluminescente est bien connue de l'homme de l'art et n'est pas décrite en détail.

Dans la description qui suit, lorsque l'on fait référence à des qualificatifs de position relative, tels que les termes "dessus", "supérieur", "inférieur", etc., il est fait référence à l'orientation des figures ou à un dispositif optoélectronique dans une position normale d'utilisation. Sauf indication contraire, les termes "sensiblement", "environ", et "de l'ordre de" signifient "à 10 % près", de préférence à 5 % près. En outre, on appelle "zone active" d'une diode électroluminescente la région de la diode électroluminescente depuis laquelle est émise la majorité du rayonnement électromagnétique fourni par la diode électroluminescente.

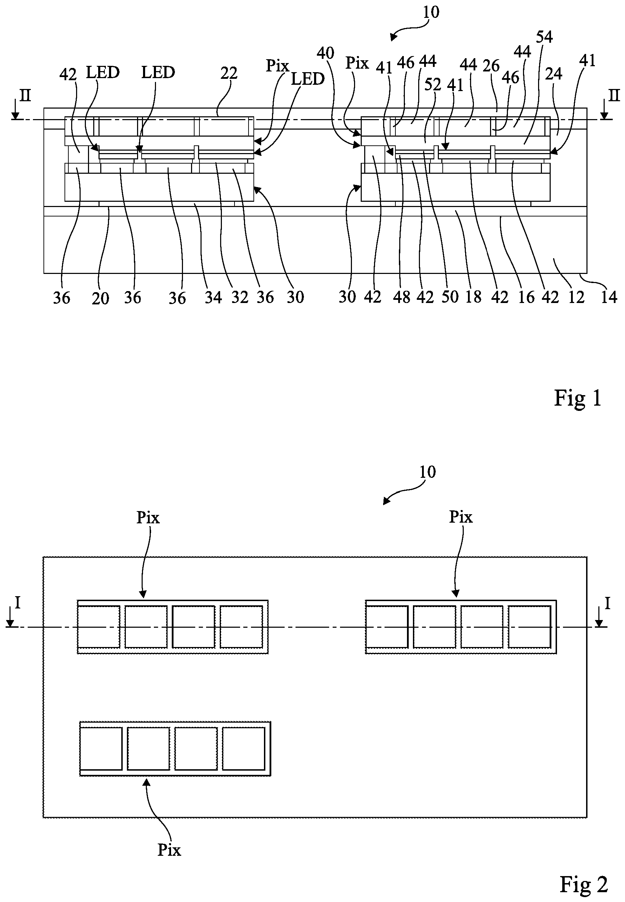

Les figures 1 et 2 représentent un mode de réalisation d'un dispositif optoélectronique 10, par exemple correspondant à un écran d'affichage ou à un dispositif de projection d'images, comprenant des pixels d'affichage. La figure 1 est une coupe de la figure 2 selon la ligne I-I et la figure 2 est une coupe de la figure 1 selon la ligne II-II.

Le dispositif 10 comprend du bas vers le haut en figure 1 :
un support 12 comprenant des faces inférieure et supérieure opposées 14, 16, de préférence parallèles ;
une première couche d'électrode 18 comprenant une couche conductrice électriquement recouvrant la face supérieure 16 ;
des pixels d'affichage Pix, également appelés circuits de pixel d'affichage par la suite, reposant sur la couche d'électrode 18 et au contact de la couche d'électrode 18, deux pixels d'affichage Pix étant représentés en figure 1 et trois pixels d'affichage Pix étant représentés en figure 2, chaque pixel d'affichage Pix comprenant une face inférieure 20 et une face supérieure 22 opposée à la face inférieure 20, chaque circuit de pixel d'affichage comprenant des diodes électroluminescentes LED émettant de la lumière par la face supérieure 22 ;
une couche isolante électriquement 24 recouvrant la couche d'électrode 18 entre les pixels d'affichage Pix et recouvrant les flancs latéraux des pixels d'affichage Pix ; et
une deuxième couche d'électrode 26 comprenant une couche conductrice électriquement au moins partiellement transparente aux rayonnements émis par les diodes électroluminescentes LED, la couche conductrice 26 recouvrant chaque pixel d'affichage Pix et recouvrant la couche isolante 24 entre les pixels d'affichage Pix, la couche conductrice 26 étant au contact de la face supérieure 22 de chaque pixel d'affichage Pix.

Chaque pixel d'affichage Pix comprend du bas vers le haut en figure 1 :
un circuit électronique 30, appelé circuit de commande par la suite ; et
un circuit optoélectronique 40.

Le circuit de commande 30 comprend la face inférieure 20 et une face supérieure 32 opposée à la face inférieure 20, les faces 20 et 32 étant de préférence parallèles. La face inférieure 20 est fixée à la couche d'électrode 18, et est par exemple délimitée par un plot conducteur électriquement 34 reliée électriquement à la couche d'électrode 18. Le circuit de commande 30 comprend en outre des plots conducteurs électriquement 36 du côté de la face supérieure 32.

Le circuit optoélectronique 40 est fixé à la face supérieure 32 du circuit de commande 30. Il comprend des empilements 41 de couches semiconductrices formant les diodes électroluminescentes LED, de préférence au moins trois diodes électroluminescentes. Le circuit optoélectronique 40 est relié électriquement au circuit électronique 30 par des plots conducteurs électriquement 42 au contact des plots conducteurs électriquement 36. Le circuit optoélectronique 40 comprend des blocs photoluminescents 44 recouvrant les diodes électroluminescentes LED du côté opposé au circuit de commande 30 et séparés latéralement par des murs 46 conducteurs électriquement. De préférence, chaque bloc photoluminescent 44 est en vis-à-vis de l'une des diodes électroluminescentes LED. Les murs 46 sont au contact de l'empilement 41 et au contact de la deuxième couche d'électrode 26. En figure 2, les diodes électroluminescentes LED et les blocs photoluminescents 44 de chaque pixel d'affichage Pix ont été représentées de façon alignée. Toutefois, il est clair que la disposition des diodes électroluminescentes LED et des blocs photoluminescents 44 peut être différente. A titre d'exemple, chaque pixel d'affichage Pix peut avoir, en vue de dessus, une forme sensiblement carrée, les diodes électroluminescentes LED et les blocs photoluminescents 44 étant agencés à trois des coins du carré.

Une couche d'encapsulation, non représentée, peut recouvrir la deuxième couche d'électrode 26.

La face inférieure 20 du circuit électronique 30 peut être fixée à la couche d'électrode 18 par un matériau de collage qui est de préférence conducteur électriquement.

Chaque diode électroluminescente LED peut correspondre à une diode électroluminescente dite bidimensionnelle comprenant un empilement de couches semiconductrices sensiblement planes dont la couche active est la couche depuis laquelle est émise la majorité du rayonnement fourni par la diode électroluminescente LED. Selon un mode de réalisation, toutes les diodes électroluminescentes LED du circuit optoélectronique 40 émettent de préférence un rayonnement lumineux sensiblement à la même longueur d'onde.

Selon un mode de réalisation, l'empilement 41 comprend, pour chaque diode électroluminescente LED, une couche semiconductrice 48 dopée d'un premier type de conductivité, par exemple dopé de type P, au contact d'un plot conducteur 42, une couche active 50 au contact de la couche semiconductrice 48 et une couche semiconductrice 52 dopée d'un deuxième type de conductivité opposé au premier type de conductivité, par exemple dopée de type N, au contact de la couche active 50. Le circuit optoélectronique 40 comprend, en outre, une couche semiconductrice 54 au contact des couches semiconductrices 52 des diodes électroluminescentes et sur laquelle reposent les murs 46. La couche semiconductrice 54 est, par exemple, du même matériau que les couches semiconductrices 52. Selon un mode de réalisation, chaque circuit optoélectronique 40 comprend, pour chaque diode électroluminescente, un plot conducteur 42 reliant la couche semiconductrice 48 au circuit électronique 30, et au moins un plot semiconducteur 42 reliant la couche semiconductrice 54 directement au circuit électronique 30.

Pour chaque diode électroluminescente LED, la couche active 50 peut comporter des moyens de confinement. A titre d'exemple, la couche 50 peut comprendre un puits quantique unique. Elle comprend alors un matériau semiconducteur différent du matériau semiconducteur formant les couches semiconductrices 48 et 52 et ayant une bande interdite inférieure à celle du matériau formant les couches semiconductrices 48 et 52. La couche active 50 peut comprendre des puits quantiques multiples. Elle comprend alors un empilement de couches semiconductrices formant une alternance de puits quantiques et de couches barrières.

Pour chaque pixel d'affichage Pix, le circuit optoélectronique 40 peut être fixé au circuit de commande 30 par une liaison de type "Flip-Chip". Les éléments conducteurs fusibles non représentés, par exemple des billes de soudure ou des billes d'indium, qui relient le circuit optoélectronique 40 au circuit de commande 30 assurent la liaison mécanique entre le circuit optoélectronique 40 et le circuit de commande 30 et assurent, en outre, la connexion électrique de chaque diode électroluminescente LED du circuit optoélectronique 40 au circuit de commande 30. Selon un autre mode de réalisation, le circuit optoélectronique 40 peut être fixé au circuit de commande 30 par collage direct. Il peut s'agir d'un collage direct hétérogène. Ceci signifie que des éléments métalliques du circuit optoélectronique 40 sont en contact avec des éléments métalliques du circuit de commande 30 et des éléments diélectriques du circuit optoélectronique 40 sont en contact avec des éléments diélectriques du circuit de commande 30.

Selon un mode de réalisation, chaque bloc photoluminescent 44 est situé en vis-à-vis de l'une des diodes électroluminescentes LED. Chaque bloc photoluminescent 44 comprend des luminophores adaptés, lorsqu'ils sont excités par la lumière émis par la diode électroluminescente LED associée, à émettre de la lumière à une longueur d'onde différente de la longueur d'onde de la lumière émise par la diode électroluminescente LED associée. Selon un mode de réalisation, chaque pixel d'affichage Pix comprend au moins deux types de blocs photoluminescents 44. Le bloc photoluminescent 44 du premier type est adapté à convertir le rayonnement fourni par les diodes électroluminescentes LED en un premier rayonnement à une première longueur d'onde et le bloc photoluminescent 44 du deuxième type est adapté à convertir le rayonnement fourni par les diodes électroluminescentes LED en un deuxième rayonnement à une deuxième longueur d'onde. Selon un mode de réalisation, chaque pixel d'affichage Pix comprend au moins trois types de blocs photoluminescents 44, le bloc photoluminescent 44 du troisième type étant adapté à convertir le rayonnement fourni par les diodes électroluminescentes LED en un troisième rayonnement à une troisième longueur d'onde. Les première, deuxième et troisième longueurs d'ondes peuvent être différentes.

Selon un mode de réalisation, la première longueur d'onde correspond à de la lumière bleue et est dans la plage de 430 nm à 490 nm. Selon un mode de réalisation, la deuxième longueur d'onde correspond à de la lumière verte et est dans la plage de 510 nm à 570 nm. Selon un mode de réalisation, la troisième longueur d'onde correspond à de la lumière rouge et est dans la plage de 600 nm à 720 nm. Les diodes électroluminescentes LED sont par exemple adaptées à émettre un rayonnement dans l'ultraviolet.

Selon un mode de réalisation, chaque pixel d'affichage Pix comprend un bloc photoluminescent 44 d'un quatrième type adapté à convertir le rayonnement fourni par les diodes électroluminescentes LED en un quatrième rayonnement à une quatrième longueur d'onde. Les première, deuxième, troisième et quatrième longueurs d'ondes peuvent être différentes. Selon un mode de réalisation, la quatrième longueur d'onde correspond à de la lumière jaune et est dans la plage de 570 nm à 600 nm. Selon un autre mode de réalisation, le quatrième rayonnement correspond à un rayonnement dans le proche infrarouge, notamment à une longueur d'onde entre 700 nm et 980 nm, à un rayonnement ultraviolet, ou à de la lumière blanche.

Chaque circuit de commande 30 peut comprendre des composants électroniques, non représentés, notamment des transistors, utilisés pour la commande des diodes électroluminescentes. Chaque circuit de commande 30 peut comprendre un substrat semiconducteur dans lequel et/ou sur lequel sont formés les composants électroniques. La face inférieure 20 du circuit de commande 30 peut alors correspondre à la face arrière du substrat opposée à la face avant du substrat du côté de laquelle sont formés les composants électroniques. Le substrat semiconducteur est, par exemple, un substrat en silicium, notamment en silicium monocristallin.

De préférence, les circuits optoélectroniques 40 comprennent seulement des diodes électroluminescentes et des éléments de connexion de ces diodes électroluminescentes et les circuits de commande 30 comprennent la totalité des composants électroniques nécessaires à la commande des diodes électroluminescentes des circuits optoélectroniques 40. A titre de variante, les circuits optoélectroniques 40 peuvent également comprendre d'autres composants électroniques en plus des diodes électroluminescentes.

Le dispositif optoélectronique 10 peut comprendre de 10 à 10⁹ pixels d'affichage Pix. Chaque pixel d'affichage Pix peut occuper en vue de dessus une surface comprise entre 1 µm² et 100 mm². L'épaisseur de chaque pixel d'affichage Pix peut être comprise entre 1 µm et 6 mm. L'épaisseur de chaque circuit électronique 30 peut être comprise entre 0,5 µm et 3000 µm. L'épaisseur de chaque circuit optoélectronique 40 peut être comprise entre 0,2 µm et 3000 µm.

Le support 12 peut être en un matériau isolant électriquement, comprenant par exemple un polymère, notamment une résine époxy, et en particulier le matériau FR4 utilisé pour la fabrication de circuits imprimés, ou en un matériau métallique, par exemple de l'aluminium. L'épaisseur du support 12 peut être comprise entre 10 µm et 10 mm.

La couche conductrice 18 correspond, de préférence à une couche métallique, par exemple en aluminium, en argent, en cuivre ou en zinc. L'épaisseur de la couche conductrice 18 peut être comprise entre 0,5 µm et 1000 µm.

La couche isolante 24 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), ou en oxyde d'hafnium (HfO₂). L'épaisseur maximale de chaque portion isolante 24 peut être comprise entre 0,2 µm et 1000 µm. De préférence, la couche isolante 24 est opaque aux rayonnements émis par les circuits optoélectroniques 40. La couche isolante 24 peut correspondre à une résine blanche, à une résine noire ou à une résine transparente chargée, notamment en particules de d'oxyde de titane.

Chaque plot conducteur 34, 36, 42 peut être au moins en partie en un matériau choisi dans le groupe comprenant le cuivre, le titane, le nickel, l'or, l'étain, l'aluminium et les alliages d'au moins deux de ces composés.

La couche conductrice 26 est adaptée à laisser passer le rayonnement électromagnétique émis par les circuits optoélectroniques 40. Le matériau formant la couche conductrice 26 peut être un matériau transparent et conducteur tel que de l'oxyde d'indium-étain (ou ITO, acronyme anglais pour Indium Tin Oxide), de l'oxyde de zinc dopé à l'aluminium ou au gallium, ou du graphène. L'épaisseur minimale de la couche conductrice électriquement 26 sur les pixels d'affichage Pix peut être comprise entre 0,05 µm et 1000 µm.

Les couches semiconductrices 48, 52, 54 sont, au moins en partie, formées à partir d'au moins un matériau semiconducteur. Le matériau semiconducteur est choisi parmi le groupe comprenant les composés III-V, par exemple un composé III-N, les composés II-VI ou les semiconducteurs ou composés du groupe IV. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC).

Selon un mode de réalisation, chaque bloc photoluminescent 44 comprend des particules d'au moins un matériau photoluminescent. Un exemple d'un matériau photoluminescent est le grenat d'yttrium et d'aluminium (YAG) activé par l'ion cérium trivalent, également appelé YAG:Ce ou YAG:Ce³⁺. La taille moyenne des particules des matériaux photoluminescents classiques est généralement supérieure à 5 µm.

Selon un mode de réalisation, chaque bloc photoluminescent 44 comprend une matrice dans laquelle sont dispersées des particules monocristallines de taille nanométrique d'un matériau semiconducteur, également appelées nanocristaux semiconducteurs ou particules de nanoluminophores par la suite. Le rendement quantique interne QYᵢₙₜ d'un matériau photoluminescent est égal au rapport entre le nombre de photons émis et le nombre de photons absorbés par la substance photoluminescente. Le rendement quantique interne QYᵢₙₜ des nanocristaux semiconducteurs est supérieur à 5 %, de préférence supérieur à 10 %, plus préférentiellement supérieur à 20 %.

Selon un mode de réalisation, la taille moyenne des nanocristaux est dans la plage de 0,5 nm et 1000 nm, de préférence de 0,5 nm à 500 nm, encore plus préférentiellement de 1 nm à 100 nm, notamment de 2 nm à 30 nm. Pour des dimensions inférieures à 50 nm, les propriétés de photoconversion des nanocristaux semiconducteurs dépendent essentiellement de phénomènes de confinement quantique. Les nanocristaux semiconducteurs correspondent alors à des boîtes quantiques.

Selon un mode de réalisation, le matériau semiconducteur des nanocristaux semiconducteurs est choisi parmi le groupe comprenant le séléniure de cadmium (CdSe), le phosphure d'indium (InP), le sulfure de cadmium (CdS), le sulfure de zinc (ZnS), le séléniure de zinc (ZnSe), le tellurure de cadmium (CdTe), le tellurure de zinc (ZnTe), l'oxyde de cadmium (CdO), l'oxyde de zinc et de cadmium (ZnCdO), le sulfure de zinc et de cadmium (CdZnS), le séléniure de zinc et de cadmium (CdZnSe), le sulfure d'argent et d'indium (AgInS₂), les pérovskites du type PbScX₃, où X est un atome d'halogène, notamment l'iode (I), le brome (Br) ou le chlore (Cl), et un mélange d'au moins deux de ces composés. Selon un mode de réalisation, le matériau semiconducteur des nanocristaux semiconducteurs est choisi parmi les matériaux cités dans la publication au nom de Le Blevenec et al. de Physica Status Solidi (RRL) - Rapid Research Letters Volume 8, No. 4, pages 349-352, avril 2014.

Selon un mode de réalisation, les dimensions des nanocristaux semiconducteurs sont choisies selon la longueur d'onde recherchée du rayonnement émis par les nanocristaux semiconducteurs. A titre d'exemple, des nanocristaux de CdSe dont la taille moyenne est de l'ordre de 3, 6 nm sont adaptés à convertir de la lumière bleue en lumière rouge et des nanocristaux de CdSe dont la taille moyenne est de l'ordre de 1,3 nm sont adaptés à convertir de la lumière bleue en lumière verte. Selon un autre mode de réalisation, la composition des nanocristaux semiconducteurs est choisie selon la longueur d'onde recherchée du rayonnement émis par les nanocristaux semiconducteurs.

La matrice est en un matériau au moins en partie transparent. La matrice est, par exemple, en silice. La matrice est, par exemple, en n'importe quel polymère au moins en partie transparent, notamment en silicone, en époxy ou en acide polyacétique (PLA). La matrice peut être en un polymère au moins en partie transparent utilisé avec les imprimantes tridimensionnelles, tels que le PLA. Selon un mode de réalisation, la matrice contient de 2 % à 90 %, de préférence de 10 % à 60 %, en poids de nanocristaux, par exemple environ 30 % en poids de nanocristaux.

L'épaisseur des blocs photoluminescents 44 dépend de la concentration de nanocristaux et du type de nanocristaux utilisé. La hauteur des blocs photoluminescents 44 est de préférence inférieure ou égale à la hauteur des murs 46. Dans la vue de la figure 2, l'aire de chaque bloc photoluminescent 44 correspond à l'aire d'un carré ayant un côté mesurant de 1 µm à 100 µm, de préférence de 3 µm à 15 µm.

Les murs 46 sont au moins en partie en au moins un matériau semiconducteur ou conducteur. Le matériau semiconducteur ou conducteur métallique peut être le silicium, le germanium, le carbure de silicium, un composé III-V, un composé II-VI, l'acier, le fer, le cuivre, l'aluminium, le tungstène, le titane, l'hafnium, le zirconium ou une combinaison d'au moins deux de ces composés. De préférence, les murs 46 sont formés en un matériau semiconducteur compatible avec les procédés de fabrication mis en oeuvre en microélectronique. Les murs 46 peuvent être fortement dopés, légèrement dopés ou non dopés. De préférence, les murs 30 sont formés en silicium monocristallin.

La hauteur des murs 46, mesurée selon une direction perpendiculaire à la face 14, est dans la plage de 300 nm à 200 µm, de préférence de 5 µm à 30 µm. L'épaisseur des murs 46, mesurée selon une direction parallèle à la face 14, est dans la plage de 100 nm à 50 µm, de préférence de 0,5 µm à 10 µm.

Selon un mode de réalisation, les murs 46 peuvent être formés d'un matériau réfléchissant ou recouverts d'un revêtement réfléchissant à la longueur d'onde du rayonnement émis par les blocs photoluminescents 44 et/ou les diodes électroluminescentes LED.

De préférence, les murs 46 entourent les blocs photoluminescents 44. Les murs 46 réduisent alors la diaphonie entre blocs photoluminescents 44 adjacents.

La couche d'encapsulation peut être réalisée en un matériau isolant au moins partiellement transparent. La couche d'encapsulation peut être réalisée en un matériau inorganique au moins partiellement transparent. A titre d'exemple, le matériau inorganique est choisi parmi le groupe comprenant les oxydes de silicium du type SiOₓ où x est un nombre réel compris entre 1 et 2 ou SiO_{y}N_{z} où y et z sont des nombres réels compris entre 0 et 1 et les oxydes d'aluminium, par exemple Al₂O₃. La couche d'encapsulation peut être réalisée en un matériau organique au moins partiellement transparent. A titre d'exemple, la couche d'encapsulation est un polymère silicone, un polymère époxyde, un polymère acrylique ou un polycarbonate.

Selon un mode de réalisation, une grille métallique peut être formée au-dessus de la couche conductrice et transparente 26 et en contact avec la couche conductrice et transparente 26, les pixels d'affichage Pix étant situés au niveau d'ouvertures de la grille métallique. Ceci permet d'améliorer la conduction électrique sans entraver le rayonnement émis par les pixels d'affichage Pix.

Selon un mode de réalisation, une grille métallique peut être formée le long et en contact de la couche conductrice et transparente 26, de manière à avantageusement favoriser la conduction du courant électrique sans bloquer les rayons lumineux.

Selon un mode de réalisation, en fonctionnement, une tension V_{E} est appliquée entre les couches d'électrode 26 et 18 pour l'alimentation des pixels d'affichage Pix, notamment des diodes électroluminescentes des circuits optoélectroniques 40 des pixels d'affichage Pix.

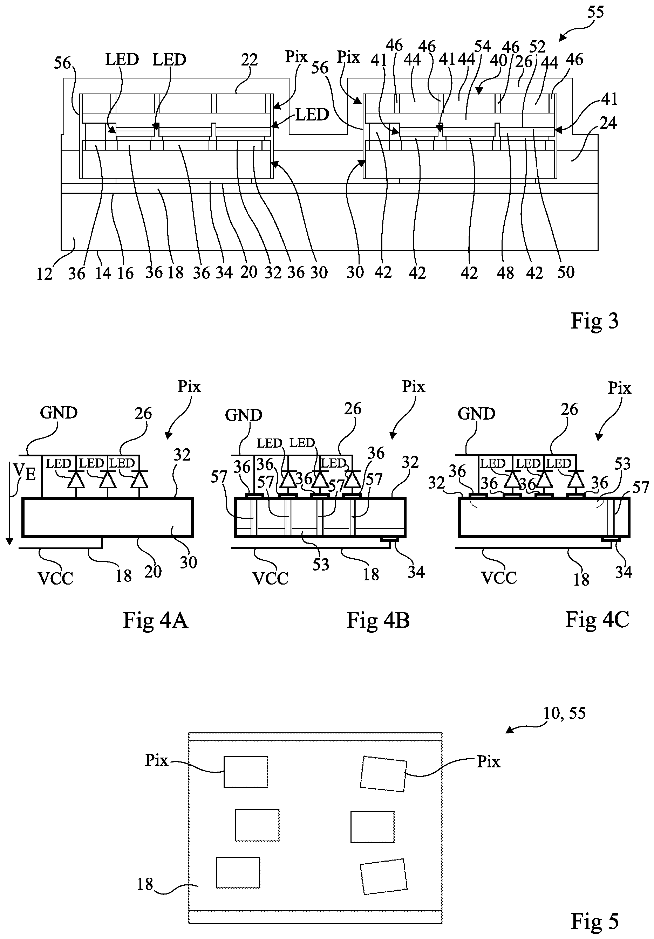

La figure 3 est une vue analogue à la figure 1 d'un autre mode de réalisation d'un dispositif optoélectronique 55 comprenant l'ensemble des éléments du dispositif optoélectronique 10 et dans lequel, chaque pixel d'affichage Pix comprend en outre une couche isolante électriquement 56 recouvrant les flancs du pixel d'affichage Pix. L'épaisseur minimale de la couche isolante 56 peut être comprise entre 2 nm et 1 mm. La couche d'électrode 26, en plus de recouvrir la face supérieure 22 de chaque pixel d'affichage Pix, peut recouvrir une partie de la couche isolante 56 du pixel d'affichage Pix. Les couches isolantes 56 peuvent être en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), en oxyde d'hafnium (HfO₂) ou en oxyde de zirconium (ZrO₂).

La figure 4A représente un schéma électrique équivalent du pixel d'affichage Pix représenté sur les figures 1 et 3. Une première électrode, par exemple la cathode, de chaque diode électroluminescente LED est connectée au circuit de commande 30 du pixel d'affichage Pix tandis que la deuxième électrode de chaque diode électroluminescente LED, par exemple l'anode, est connectée à la couche d'électrode 26, elle-même reliée à une source d'un potentiel de référence bas GND, par exemple la masse. Le circuit de commande 30 est connecté à la couche d'électrode 18 qui est reliée à une source d'un potentiel de référence haut VCC. Le pixel d'affichage Pix est connecté entre les couches d'électrode 18 et 26 et reçoit la tension V_{E}. Le circuit 30 commande les diodes électroluminescentes LED du circuit optoélectronique 40.

La figure 4B est une figure analogue à la figure 4A dans laquelle le circuit de commande 30 est représenté avec une région active 53 disposée du côté de la face inférieure 20. La région active 53 est la région du circuit de commande 30 dans et sur laquelle sont formés les composants électroniques du circuit de commande 30. Le circuit de commande 30 comprend, en outre, des vias 57 s'étendant au travers du circuit de commande 30, isolés latéralement par rapport au reste du circuit de commande et reliant électriquement des pistes conductrices formées du côté de la face inférieure 20 du circuit de commande 30 aux plots conducteurs 36 situés du côté de la face supérieure 32 du circuit de commande 30. En particulier, l'un des vias 57 permet de ramener le potentiel fourni par la source du potentiel de référence bas GND jusqu'à la région active 53.

La figure 4C est une figure analogue à la figure 4A dans laquelle le circuit de commande 30 est représenté avec la région active 53 disposée du côté de la face supérieure 32. Le circuit de commande 30 comprend, en outre, au moins un via 57 s'étendant au travers du circuit de commande 30 et reliant électriquement le plot conducteur 34 situé du côté de la face inférieure 20 du circuit de commande 30 au plot conducteur 36 situé du côté de la face supérieure 32 du circuit de commande 30. Ce via 57 permet de ramener le potentiel de la source du potentiel de référence haut VCC jusqu'à la région active 53.

Dans le présent mode de réalisation, la couche conductrice 18 est en contact avec tous les pixels d'affichage Pix du dispositif optoélectronique 10, 55 et la couche conductrice 26 est en contact avec tous les pixels d'affichage Pix du dispositif optoélectronique 10, 55.

Un mode de réalisation d'un procédé de fabrication du dispositif optoélectronique 10 ou 55 comprend la fabrication des pixels d'affichage Pix et la mise en place séparément de chaque pixel d'affichage Pix sur la couche d'électrode 18. Selon un mode de réalisation, les couches d'électrode 18 et 26 étant communes à tous les pixels d'affichage Pix, la connexion des pixels d'affichage Pix est simplifiée et il n'est pas nécessaire que le placement de chaque pixel d'affichage Pix sur la couche d'électrode 18 soit réalisé avec une précision élevée. Ceci permet de façon avantageuse de mettre en oeuvre des techniques plus rapides et à coûts réduits pour disposer les pixels d'affichage Pix sur la couche d'électrode 18. En outre, comme les diodes électroluminescentes de chaque pixel d'affichage sont intégrées au circuit optoélectronique 40 du pixel d'affichage Pix, le nombre de transferts à réaliser lors du montage du dispositif optoélectronique 10 ou 55 est réduit. Dans le présent mode de réalisation, chaque pixel d'affichage Pix peut comprendre une mémoire dans laquelle est stockée un identifiant du pixel. Le procédé de fabrication peut comprendre une phase d'étalonnage dans laquelle la position de chaque pixel d'affichage Pix est récupérée en fonction de son identifiant. En fonctionnement, des données peuvent alors être transmises aux pixels en fonction de leur identifiant.

La figure 5 représente une vue de dessus schématique du dispositif optoélectronique 10 ou 55 illustrant le fait que les pixels d'affichage Pix peuvent ne pas être disposés de façon très précise, par exemple parfaitement alignés en rangées et en colonnes, et que certains pixels d'affichage Pix peuvent être inclinés par rapport aux directions des rangées et des colonnes.

Dans les modes de réalisation décrits précédemment, la couche d'électrode 18 est connectée à tous les pixels d'affichage Pix et se présente sous la forme d'une couche ininterrompue s'étendant sur la majorité, voire la totalité du support 12.

Pour chaque pixel d'affichage Pix, le circuit de commande 30 est adapté à recevoir des signaux de commande et à commander, à partir des signaux de commande reçus, les diodes électroluminescentes du pixel d'affichage, notamment la teinte, la saturation et la luminosité de la lumière émise par le pixel d'affichage.

Selon un mode de réalisation, les signaux de commande peuvent être transmis aux circuits de commande 30 des pixels d'affichage Pix par une modulation de la tension V_{E}.

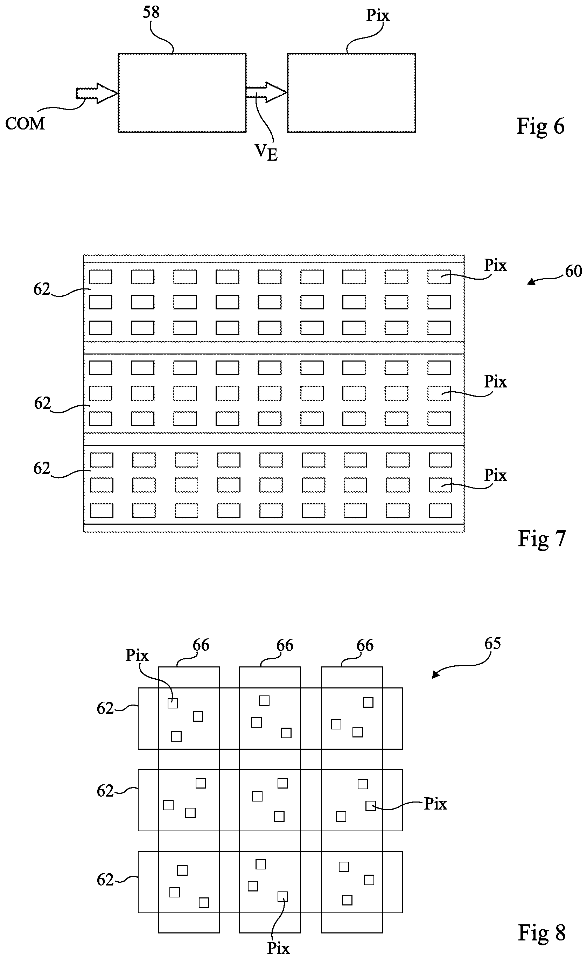

La figure 6 représente de façon très schématique un module de traitement 58 recevant des signaux de commande COM et adapté à fournir au dispositif optoélectronique 10 ou 55 une tension V_{E} d'alimentation des pixels d'affichage Pix qui est modulée avec les signaux de commande COM. Le module de traitement 58 peut correspondre à un circuit dédié ou peut comprendre un processeur, par exemple un microprocesseur ou un microcontrôleur, adapté à exécuter des instructions d'un programme d'ordinateur stocké dans une mémoire.

Le circuit de commande 30 de chaque pixel d'affichage Pix peut extraire les signaux de commande COM par démodulation de la tension V_{E}. Le circuit de commande 30 peut alors déterminer si les signaux de commande COM lui sont destinés. A titre d'exemple, un identifiant peut être associé à chaque pixel d'affichage Pix et les signaux de commande COM obtenus par démodulation de la tension V_{E} peuvent comprendre l'identifiant du pixel d'affichage auquel ces signaux de commande sont destinés.

De façon avantageuse, un adressage actif des pixels d'affichage Pix peut être réalisé. En effet, chaque circuit de commande 30 peut commander le maintien des propriétés d'affichage, notamment la teinte, la saturation et la luminosité, du pixel d'affichage jusqu'à ce qu'il reçoive de nouveaux signaux de commande.

La figure 7 représente une vue de dessus schématique d'un autre mode de réalisation d'un dispositif optoélectronique 60 comprenant l'ensemble des éléments du dispositif optoélectronique 10 ou 55 dans lequel la couche d'électrode 18 est divisée en bandes conductrices électriquement 62 parallèles s'étendant sur le support 12, trois bandes 62 étant représentées à titre d'exemple sur la figure 7. Au moins une rangée de pixels d'affichage Pix est répartie sur chaque bande conductrice 62. De préférence, plusieurs rangées de pixels d'affichage Pix sont réparties sur chaque bande conductrice 62, trois rangées de pixels d'affichage Pix étant représentées par une bande conductrice 62 à titre d'exemple sur la figure 7.

Selon un autre mode de réalisation, la couche d'électrode 18 et/ou la couche d'électrode 26 peut être divisée en bandes d'électrode distinctes. Selon un autre mode de réalisation, la couche d'électrode 26 peut également être divisée en bandes parallèles et conductrices électriquement. Lorsque les couches d'électrode 18 et 26 sont chacune divisées en bandes, les bandes de la couche d'électrode 18 ont de préférence sensiblement les mêmes dimensions que les bandes de la couche d'électrode 26 et chaque bande de la couche d'électrode 26 recouvre sensiblement une seule des bandes de la couche d'électrode 18. Selon un autre mode de réalisation, l'une des électrodes 18 ou 26 peut être commune aux pixels d'affichage Pix tandis que l'autre électrode 18 ou 26 est divisée en bandes parallèles et conductrices électriquement. Dans le mode de réalisation dans lequel les couches d'électrode 18, 26 sont divisées en bandes superposées prenant en sandwich des ensembles de pixels d'affichage, différents signaux de commande peuvent être transmis en parallèle en modulant différemment la tension V_{E} pour chaque ensemble de pixels d'affichage. Ceci permet de transmettre en parallèle les signaux de commande pour chaque ensemble de pixels d'affichage Pix. Ceci permet de réduire la fréquence de modulation du rayonnement électromagnétique et/ou d'augmenter le débit de données transmises.

La figure 8 est une vue de dessus partielle et schématique d'un autre mode de réalisation d'un dispositif optoélectronique 65 dans lequel la couche d'électrode 18 est divisée en bandes conductrices 62 s'étendant selon la direction des rangées et dans lequel la couche d'électrode 26 est divisée en bandes conductrices électriquement 66 s'étendant selon la direction des colonnes, et appelées électrodes de colonne. Au moins un pixel d'affichage Pix est disposé à l'intersection, en vue de dessus, entre chaque électrode de rangée 62 et chaque électrode de colonne 66 et est connecté à l'électrode de rangée 62 et à l'électrode de colonne 66. A titre d'exemple, en figure 8, trois pixels d'affichage Pix sont prévus à l'intersection, en vue de dessus, entre chaque électrode de rangée 62 et chaque électrode de colonne 66. Selon un mode de réalisation, les pixels d'affichage Pix à l'intersection de chaque électrode de rangée 62 et de chaque électrode de colonne 66 peuvent former un pixel de l'image à afficher. Ceci permet d'avoir une redondance au cas où l'un des pixels d'affichage Pix est défectueux. Il est à noter que, pour chaque pixel d'affichage Pix, la totalité de la face inférieure du pixel d'affichage Pix n'est pas nécessairement en contact avec l'une des électrodes de rangée 62 et/ou la totalité de la face supérieure du pixel d'affichage Pix n'est pas nécessairement en contact avec l'une des électrodes de colonne 66. Ceci signifie que le pixel d'affichage Pix peut être à cheval entre l'une des électrodes de rangée 62 et la région inter-bande adjacente et/ou que le pixel d'affichage Pix peut être à cheval entre l'une des électrodes de colonne 66 et la région inter-bande adjacente.

Selon un autre mode de réalisation, les bandes transparentes 66, pour lesquelles le dépôt sur de grandes longueurs/surfaces continues peut être compliqué, peuvent être constituées de zones discontinues, où sont connectés les pixels d'affichage, ces zones discontinues étant connectées entre elles par des pistes métalliques. Cela permet avantageusement de faciliter la formation des électrodes supérieures et d'améliorer la conductivité électrique.

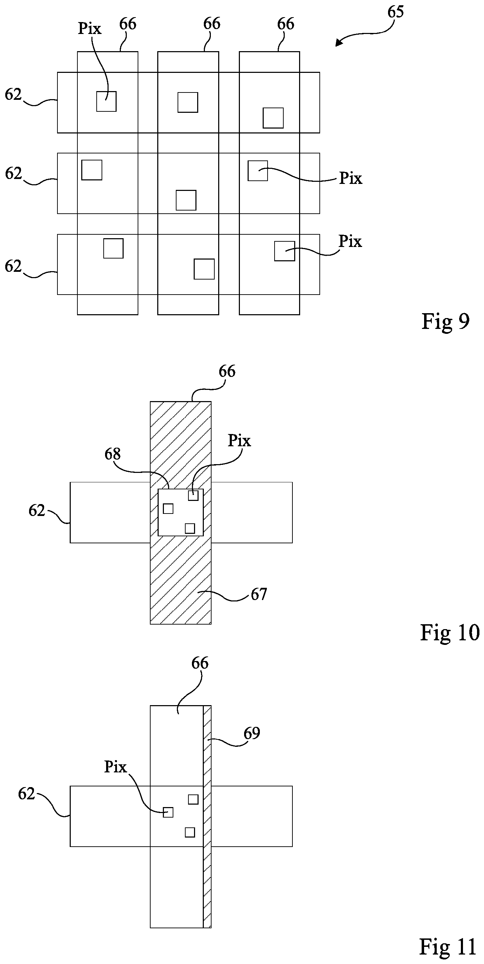

La figure 9 est une vue de dessus partielle et schématique d'un mode de réalisation du dispositif optoélectronique 65 dans lequel un seul pixel d'affichage Pix est prévu à l'intersection de chaque électrode de rangée 62 et de chaque électrode de colonne 66.

Comme cela apparaît sur la figure 9, la largeur de chaque bande conductrice 66 est de préférence supérieure à la dimension du pixel d'affichage Pix mesurée selon la direction des colonnes et la largeur de chaque bande conductrice 62 est supérieure à la dimension du pixel d'affichage Pix mesurée selon la direction des rangées, notamment pour éviter un court-circuit. De ce fait, pour chaque rangée, les pixels d'affichage Pix appartenant à la rangée peuvent ne pas être parfaitement alignés. De même, pour chaque colonne, les pixels d'affichage Pix appartenant à la colonne peuvent ne pas être parfaitement alignés.

La figure 10 est une vue de dessus, partielle et schématique, d'une variante du dispositif optoélectronique 65 dans laquelle une grille métallique 67 est formée au-dessus de chaque bande conductrice supérieure et transparente 66 et en contact avec la bande conductrice et transparente 66, les pixels d'affichage Pix étant situés au niveau d'ouvertures 68 de la grille métallique 67. Ceci permet d'améliorer la conduction électrique sans entraver le rayonnement émis par les pixels d'affichage Pix.

La figure 11 est une vue de dessus, partielle et schématique, d'une autre variante du dispositif optoélectronique 65 dans laquelle une grille métallique 69 est formée le long et en contact de chaque bande conductrice et transparente 66, de manière à avantageusement favoriser la conduction du courant électrique sans bloquer les rayons lumineux.

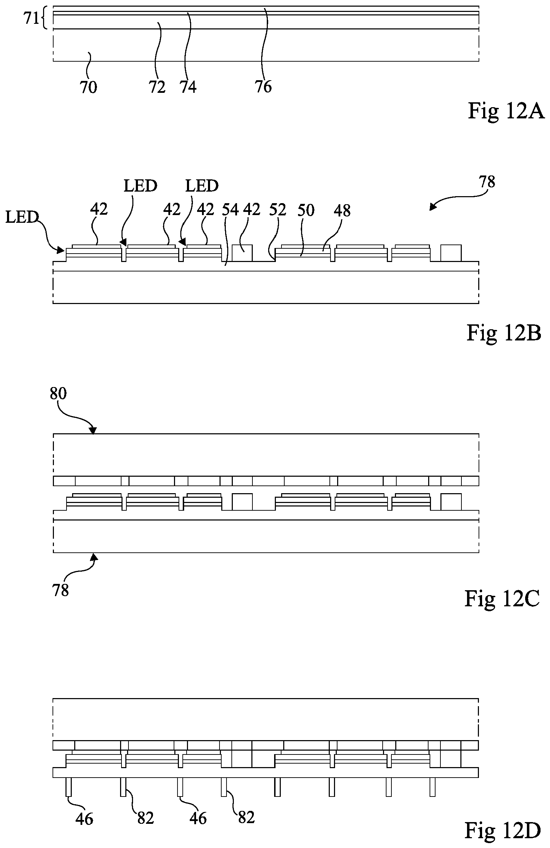

Les figures 12A à 12L sont des vues en coupe, partielles et schématiques, de structures obtenues à des étapes successives d'un mode de réalisation d'un procédé de fabrication du dispositif optoélectronique 10 représenté sur la figure 1.

La figure 12A représente la structure obtenue après la formation sur un support 70 d'un empilement 71 de couches semiconductrices, comprenant, du bas vers le haut en figure 12A, une couche semiconductrice 72, une couche active 74 et une couche semiconductrice 76. La couche semiconductrice 72 peut avoir la même composition que les couches semiconductrices 52, 54 décrites précédemment. La couche active 74 peut avoir la même composition que la couche active 50 décrite précédemment. La couche semiconductrice 76 peut avoir la même composition que la couche semiconductrice 48 décrite précédemment. Une couche de nucléation peut être prévue entre le support 70 et la couche semiconductrice 72. De préférence, il n'y a pas de couche de nucléation entre le support 70 et la couche semiconductrice 72.

La figure 12B représente la structure obtenue après la délimitation des diodes électroluminescentes LED des circuits optoélectroniques 40 et la formation des plots conducteurs 42. Les diodes électroluminescentes LED peuvent être délimitées en gravant la couche semiconductrice 72, la couche active 74 et la couche semiconductrice 76 pour délimiter, pour chaque diode électroluminescente LED de chaque circuit optoélectronique 40 la couche semiconductrice 52, la couche active 50 et la couche semiconductrice 48. La gravure mise en oeuvre peut être une gravure sèche, par exemple utilisant un plasma à base de chlore et de fluor, une gravure ionique réactive (RIE). La partie non gravée de la couche semiconductrice 72 forme la couche semiconductrice 54 décrite précédemment. Les plots conducteurs 42 peuvent être obtenus en déposant une couche conductrice sur l'ensemble de la structure obtenue et en retirant la partie de la couche conductrice en dehors des plots conducteurs 42. On obtient un circuit optoélectronique 78 comprenant plusieurs exemplaires, non encore achevés, du circuit optoélectronique 40, deux exemplaires étant représentés en figure 12B.

La figure 12C représente la structure obtenue après la fabrication d'un circuit électronique 80 comprenant plusieurs exemplaires, non complètement achevés, du circuit de commande 30 souhaité, notamment par des étapes classiques d'un procédé de fabrication d'un circuit intégré, et juste avant la fixation du circuit électronique 80 au circuit optoélectronique 78. Les méthodes d'assemblage du circuit électronique 80 au circuit optoélectronique 78 peuvent comprendre des opérations de brasage ou de collage moléculaire.

La figure 12D représente la structure obtenue après la formation des murs 46 dans le support 70. Les murs 46 peuvent être formés en gravant des ouvertures 82 dans le support 70.

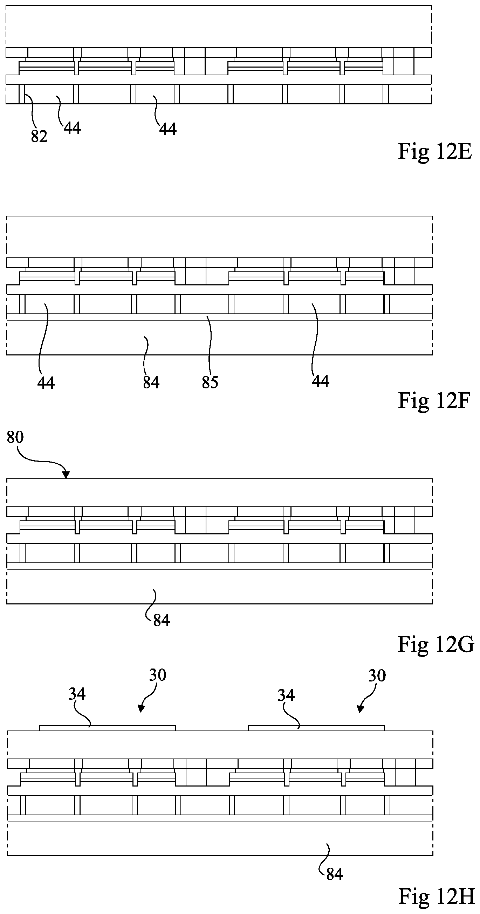

La figure 12E représente la structure obtenue après la formation des blocs photoluminescents 44. Les blocs photoluminescents 44 peuvent être formés en remplissant certaines ouvertures 82 avec une dispersion colloïdale de nanocristaux semiconducteurs dans une matrice de liaison, par exemple par un procédé dit additif, éventuellement en obturant certaines ouvertures 82 avec de la résine. Le procédé dit additif peut comprendre l'impression directe de la dispersion colloïdale aux emplacements souhaités, par exemple par impression par jet d'encre, impression par aérosol, microtamponnage, photogravure, sérigraphie, flexographie, revêtement par pulvérisation, ou dépôt de gouttes. Selon un autre mode de réalisation, les blocs photoluminescents 44 peuvent être formés avant la fabrication des murs 46.

La figure 12F représente la structure obtenue après la fixation de la structure représentée en figure 12E, du côté des blocs photoluminescents 44, à un support 84, également appelé poignée, en utilisant un matériau de liaison 85.

La figure 12G représente la structure obtenue après avoir aminci le substrat du circuit électronique 80 du côté opposé à la poignée 84.

La figure 12H représente la structure obtenue après la formation des plots conducteurs 34 des circuits de commande 30 sur le circuit électronique 80 du côté opposé à la poignée 84.

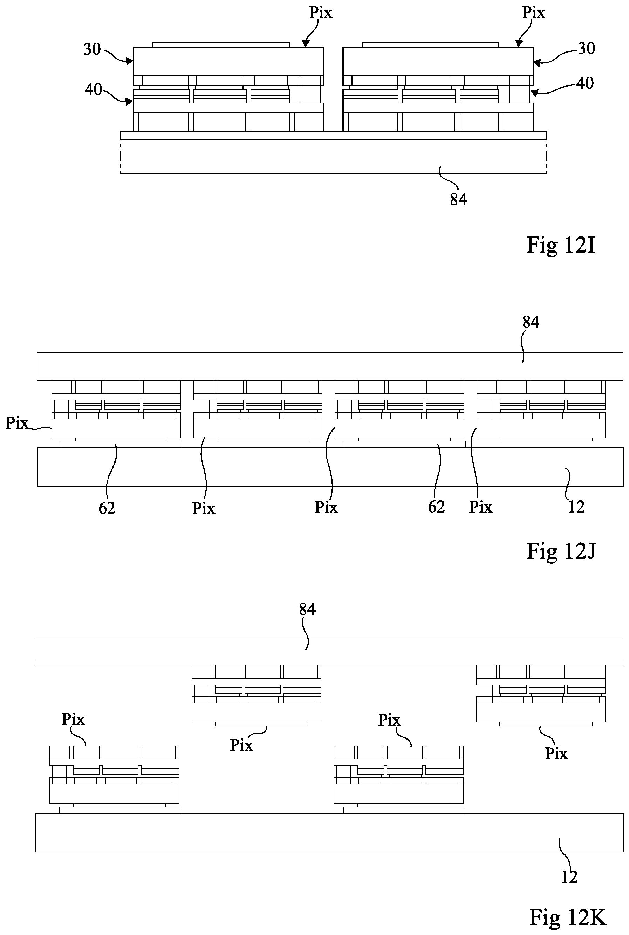

La figure 12I représente la structure obtenue après la séparation des circuits de commande 30 dans le circuit électronique 80 et des circuits optoélectroniques 40 dans le circuit optoélectronique 78. Les pixels d'affichage Pix sont ainsi délimités tout en restant fixés à la poignée 84.

La figure 12J représente la structure obtenue après la fixation de certains des pixels d'affichage Pix au support 12. Dans le présent mode de réalisation, on a représenté deux bandes conductrices 62 sur le support 12. Les pixels d'affichage Pix qui sont en contact avec les bandes conductrices 62 se fixent aux bandes conductrices 62. Les pixels d'affichage Pix qui ne sont pas au contact de bandes conductrices 62 ne sont pas fixés au support 12. A titre d'exemple, chaque pixel d'affichage Pix peut être fixé à l'une des bandes conductrices 62 par collage moléculaire ou par l'intermédiaire d'un matériau de collage, notamment une colle époxy conductrice électriquement.

La figure 12K représente la structure obtenue après la séparation de la poignée 84 des pixels d'affichage Pix fixés au support 12. Cette séparation peut être réalisée par ablation laser. Le mode de réalisation illustré sur les figures 12J et 12K permet la fixation simultanée de plusieurs pixels d'affichage Pix au support 12.

A titre de variante, après l'étape illustrée sur la figure 12I, les pixels d'affichage Pix peuvent être séparés de la poignée 84 et un procédé "pick and place" peut être mis en oeuvre consistant à placer séparément chaque pixel d'affichage Pix sur le support 12.

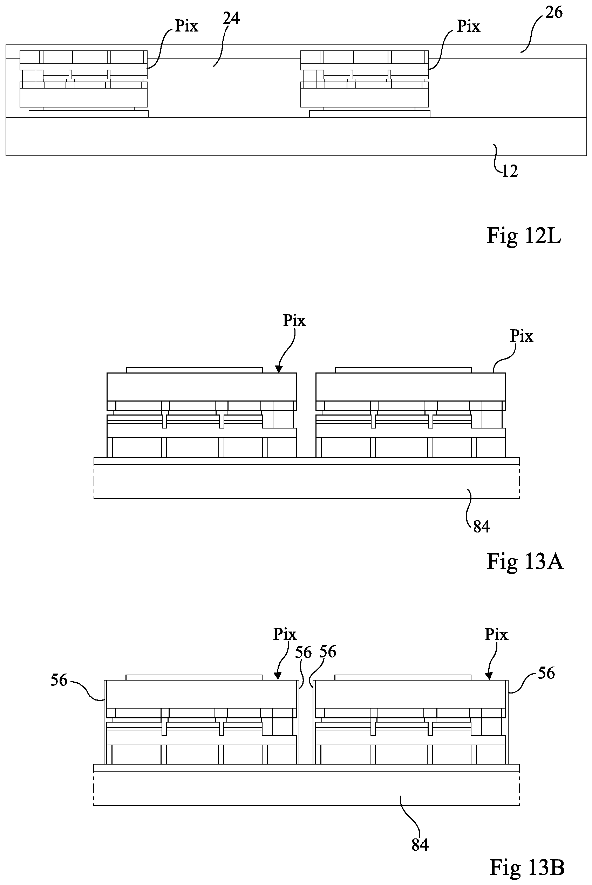

La figure 12L représente la structure obtenue après la formation de la couche isolante 24 et de la deuxième couche d'électrode 26. La couche isolante 24 peut être déposée par dépôt chimique en phase vapeur (CVD, sigle anglais pour Chemical Vapor Déposition), dépôt chimique en phase vapeur assisté par plasma (PECVD, sigle anglais pour Plasma Enhanced Chemical Vapor Déposition), ou pulvérisation cathodique. La couche d'électrode 26 peut être déposée par CVD, PECVD, ALD, pulvérisation cathodique ou évaporation.

Les figures 13A à 13E sont des vues en coupe, partielles et schématiques, de structures obtenues à des étapes successives d'un mode de réalisation d'un procédé de fabrication du dispositif optoélectronique 55 représenté sur la figure 3.

La figure 13A représente la structure obtenue après la mise en oeuvre des étapes décrites précédemment en relation avec les figures 12A à 12I.

La figure 13B représente la structure obtenue après la formation, pour chaque pixel d'affichage Pix, de la couche isolante 56 sur les flancs du pixel d'affichage Pix. La couche isolante 56 peut être déposée par dépôt chimique en phase vapeur (CVD, sigle anglais pour Chemical Vapor Déposition), dépôt chimique en phase vapeur assisté par plasma (PECVD, sigle anglais pour Plasma Enhanced Chemical Vapor Déposition), dépôt de couches minces atomiques (ALD, sigle anglais pour Atomic Layer Déposition) ou pulvérisation cathodique. Il peut s'agir d'un dépôt conforme suivi d'une gravure sélective.

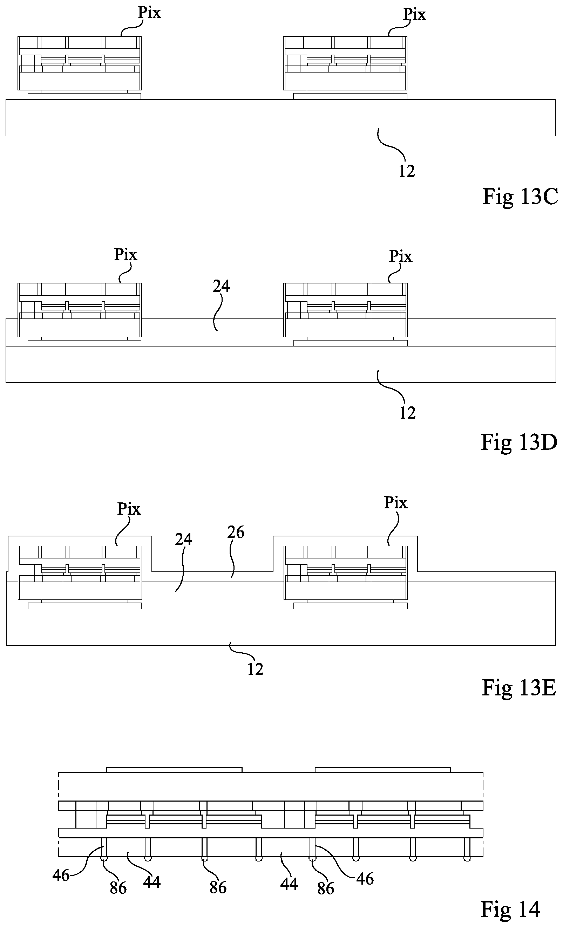

La figure 13C représente la structure obtenue après la fixation des pixels d'affichage Pix sur le support 12, par exemple par la mise en oeuvre des étapes décrites précédemment en relation avec les figures 12J et 12K.

La figure 13D représente la structure obtenue après la formation de la couche isolante 24, par exemple comme cela a été décrit précédemment en relation avec la figure 12L.

La figure 13E représente la structure obtenue après la formation de la deuxième couche d'électrode 26, par exemple comme cela a été décrit précédemment en relation avec la figure 12L. De façon avantageuse, la présence de la couche isolante 56 sur les flancs de chaque pixel d'affichage Pix permet d'empêcher la formation d'un contact électrique entre la couche d'électrode 26 et un élément conducteur, qui en l'absence de la couche isolante 56, serait exposé sur les flancs du pixel d'affichage Pix. L'épaisseur de la couche isolante 24 n'a alors pas besoin d'être définie avec précision.

La figure 14 représente la structure obtenue pour une variante d'un procédé de fabrication du dispositif optoélectronique 10, dans lequel, après l'étape décrite précédemment en relation avec la figure 12H, la poignée 84 est retirée et des bandes conductrices électriquement 86 sont formées aux extrémités des murs 46 opposés aux diodes électroluminescentes LED. Ceci permet d'améliorer la liaison électrique entre les murs 46 et la couche d'électrode 26. Les bandes conductrices 86 sont, par exemple, au moins en partie en aluminium, en argent, en cuivre ou en zinc. L'épaisseur des bandes conductrices 86 peut être comprise entre 50 nm et 2 mm.

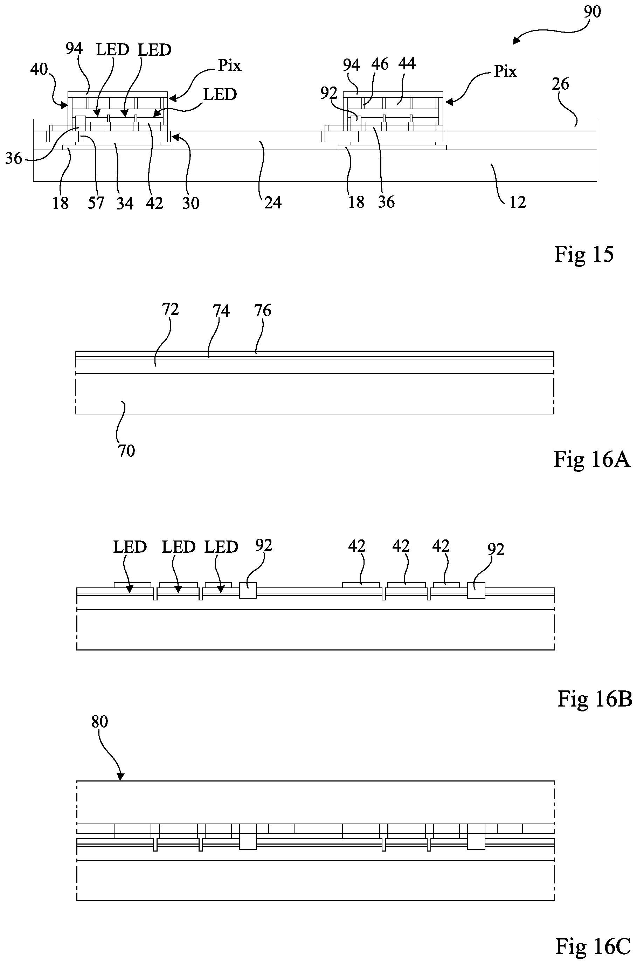

La figure 15 est une vue analogue à la figure 3 d'un autre mode de réalisation d'un dispositif optoélectronique 90 comprenant l'ensemble des éléments du dispositif optoélectronique 55 à la différence que la couche d'électrode 26 ne recouvre pas les pixels d'affichage Pix et que le plot conducteur 36 connecté à la couche semiconductrice 54 est remplacé par un élément de connexion 92 formant un via isolé latéralement et traversant la couche semiconductrice 48 et la couche active 50 et s'arrêtant dans la couche semiconductrice 54 et qui se prolonge, à l'extérieur de la couche semiconductrice 48, par un plot conducteur. En outre, chaque pixel d'affichage Pix comprend une couche isolante 94 recouvrant les blocs photoluminescents 44 et les extrémités des murs 46 opposées à la couche semiconductrice 54, l'un des plots conducteurs 36 du circuit de commande 30 étant en contact avec la deuxième couche d'électrode 26 et le circuit de commande 30 comprenant un via 57 reliant le plot conducteur 34 à l'un des plots conducteurs 36.

Le présent mode de réalisation permet de relier la deuxième couche d'électrode 26 à la source du potentiel de référence haut VDD et la couche d'électrode 18 à la source du potentiel de référence bas tout en utilisant un circuit de commande 30 dont la région active est située du côté de la face supérieure 32 du circuit de commande 30. En effet, le potentiel de référence bas GND est amené jusqu'aux cathodes des diodes électroluminescentes LED par l'intermédiaire du via traversant 57 qui relie le plot conducteur 34 au plot conducteur 36 connecté à l'élément de connexion 92 et le potentiel de référence haut VCC est amené à la région active du circuit de commande 30 par le plot conducteur 36 connecté à la couche d'électrode 26.

Les figures 16A à 16K sont des vues en coupe, partielles et schématiques, de structures obtenues à des étapes successives d'un mode de réalisation d'un procédé de fabrication du dispositif optoélectronique 90 représenté sur la figure 15.

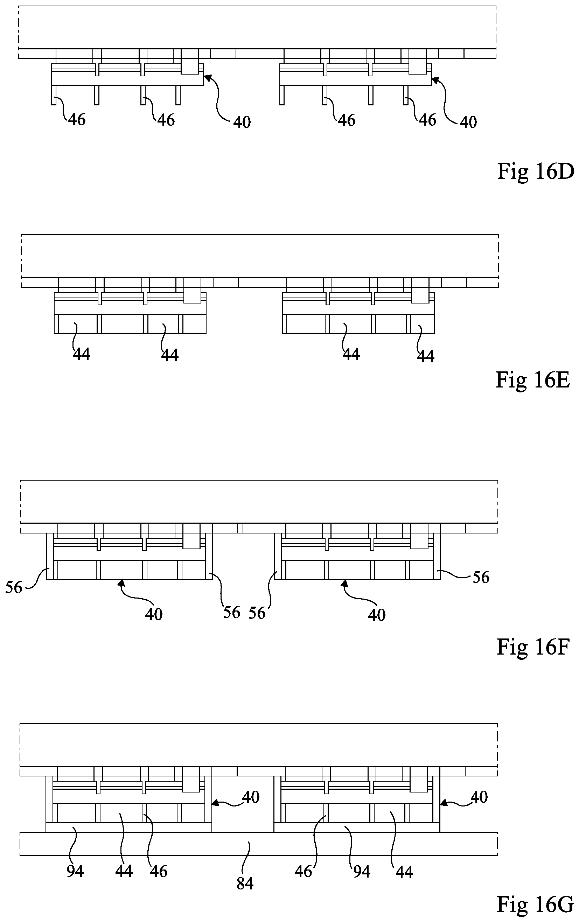

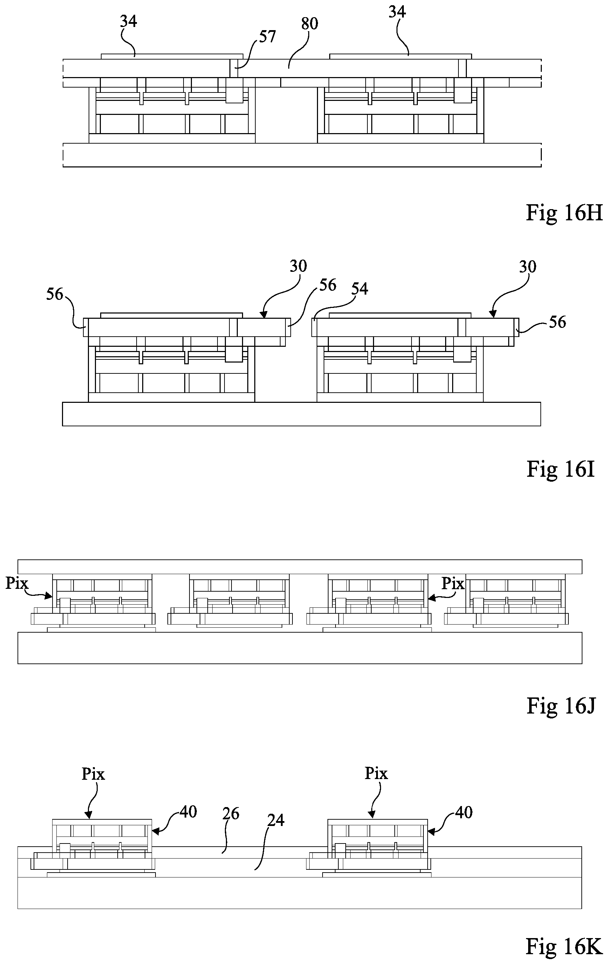

Le présent mode de réalisation du procédé de fabrication comprend les étapes suivantes :
- formation des couches semiconductrices 72, 74, 76 sur le support 70 (figure 16A) comme cela a été décrit précédemment en relation avec la figure 12A ;
- formation des diodes électroluminescentes LED et des plots conducteurs 42 (figure 16B) comme cela a été décrit précédemment en relation avec la figure 12B et formation de l'élément de connexion 92 ;
- fixation du circuit électronique 80 (figure 16C) comme cela a été décrit précédemment en relation avec la figure 12C ;
- formation des murs 46 (figure 16D) comme cela a été décrit précédemment en relation avec la figure 12D et séparation des circuits optoélectroniques 40 ;
- formation des blocs photoluminescents 44 (figure 16E) comme cela a été décrit précédemment en relation avec la figure 12E ;
- formation de la couche isolante 56 sur les parois latérales de chaque circuit optoélectronique 40 (figure 16F) comme cela a été décrit précédemment en relation avec la figure 13B ;
- formation de la couche isolante 94 recouvrant, pour chaque circuit optoélectronique 40, les blocs photoluminescents 44 et les murs 46 et fixation d'une poignée 84 (figure 16G) comme cela a été décrit précédemment en relation avec la figure 12F ;
- amincissement du substrat du circuit électronique 80, formation du via 57 et formation des plots conducteurs 34 (figure 16H) comme cela a été décrit précédemment en relation avec les figures 12G et 12H ;
- séparation des circuits électroniques 30 (figure 16I) et formation de couches isolantes 56 sur les parois latérales des circuits électroniques 30 comme cela a été décrit précédemment en relation avec la figure 13B ;
- fixation de certains des pixels d'affichage Pix au support 12 (figure 16J) comme cela a été décrit précédemment en relation avec la figure 12J ; et
- formation de la couche isolante 24 et de la couche d'électrode 26 (figure 16K) de manière analogue à ce qui a été décrit précédemment en relation avec la figure 12L à la différence que la couche d'électrode 26 ne recouvre pas les circuit optoélectroniques 40 des pixels d'affichage Pix.

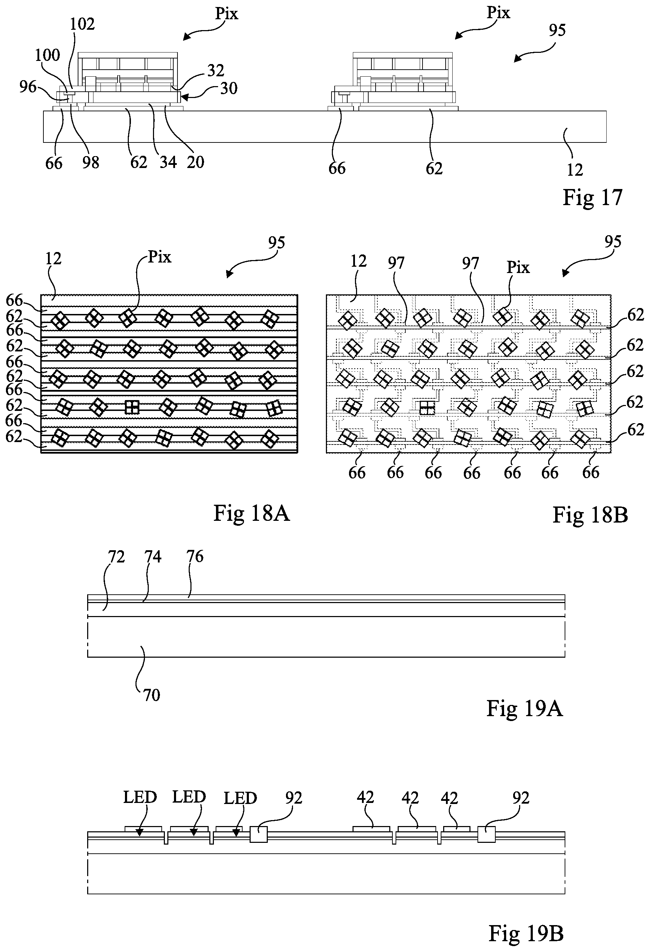

Les figures 17 et 18A sont respectivement une vue en coupe et une vue de dessus, analogues aux figures 1 et 2, d'un autre mode de réalisation d'un dispositif optoélectronique 95. Le dispositif 95 comprend l'ensemble des éléments du dispositif optoélectronique 90 à la différence que les bandes conductrices 66 sont disposées sur le substrat 12 comme les bandes conductrices 62, les bandes conductrices 62 et 66 étant par exemple parallèles. La couche isolante 24 peut alors ne pas être présente. Pour chaque pixel d'affichage Pix, le circuit de commande 30 du pixel d'affichage 30 comprend un via traversant 96 s'étendant au travers du circuit de commande 30, isolés latéralement par rapport au reste du circuit de commande et reliant électriquement une piste conductrices 98 formée du côté de la face inférieure 20 du circuit de commande 30 à une zone conductrice 100 située du côté de la face supérieure 32 du circuit de commande 30 mais recouverte d'une couche isolante 102. Ce via 96 permet de ramener le potentiel fourni par la source du potentiel de référence haut VCC jusqu'à la face supérieure 32 du circuit de commande 30.

La figure 18B est une variante de la figure 18A dans laquelle les bandes conductrice 62 sont agencées selon les rangées de pixels d'affichage Pix et les bandes conductrices 66 sont agencées selon les rangées de pixels d'affichage Pix. Des blocs 97 isolants électriquement sont interposés entre les bandes conductrices 62 et 66 aux intersections entre les bandes conductrices.

Les figures 19A à 19J sont des vues en coupe, partielles et schématiques, de structures obtenues à des étapes successives d'un mode de réalisation d'un procédé de fabrication du dispositif optoélectronique 95 représenté sur les figures 17, 18A et 18B.

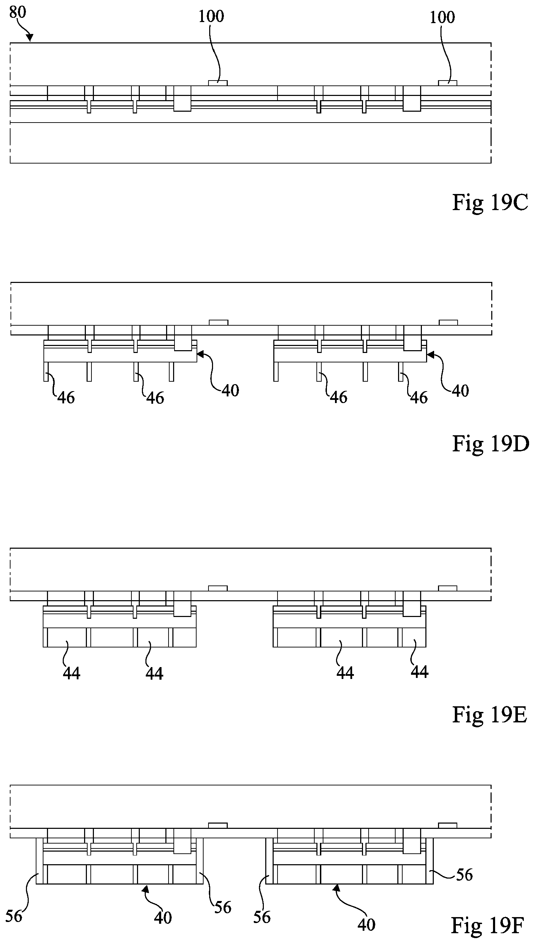

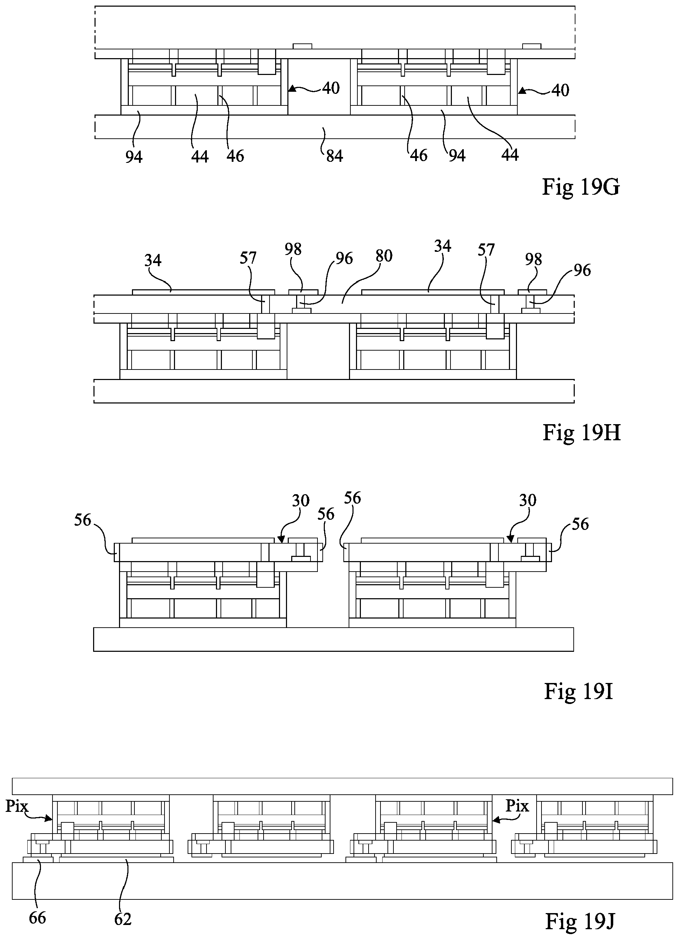

Le présent mode de réalisation du procédé de fabrication comprend les étapes suivantes :
- formation des couches semiconductrices 72, 74, 76 sur le support 70 (figure 19A) comme cela a été décrit précédemment en relation avec la figure 14A ;
- formation des diodes électroluminescentes LED et des plots conducteurs 42 (figure 19B) comme cela a été décrit précédemment en relation avec la figure 14B et formation de l'élément de connexion 92 ;
- fixation du circuit électronique 80 (figure 19C) comme cela a été décrit précédemment en relation avec la figure 14C, le circuit électronique 80 comprenant notamment la zone conductrice 100 du côté de la face 32 ;
- formation des murs 46 (figure 19D) comme cela a été décrit précédemment en relation avec la figure 14D et séparation des circuits optoélectroniques 40 ;
- formation des blocs photoluminescents 44 (figure 19E) comme cela a été décrit précédemment en relation avec la figure 14E ;
- formation de la couche isolante 56 sur les parois latérales de chaque circuit optoélectronique 40 (figure 19F) comme cela a été décrit précédemment en relation avec la figure 15B ;
- formation de la couche isolante 94 recouvrant, pour chaque circuit optoélectronique 40, les blocs photoluminescents 44 et les murs 46 et fixation d'une poignée 84 (figure 19G) comme cela a été décrit précédemment en relation avec la figure 14F ;
- amincissement du substrat du circuit électronique 80, formation des vias 57 et 96, et formation des plots conducteurs 34 et 98 (figure 19H) comme cela a été décrit précédemment en relation avec les figures 14G et 14H ;
- séparation des circuits électroniques 30 (figure 19I) et formation de couches isolantes 56 sur les parois latérales des circuits électroniques 30 comme cela a été décrit précédemment en relation avec la figure 15B ; et
- fixation de certains des pixels d'affichage Pix au support 12 (figure 19J) comme cela a été décrit précédemment en relation avec la figure 14J à la différence que les plots conducteurs 34 viennent au contact des bandes conductrices 62 et que les plots conducteurs 98 viennent au contact des bandes conductrices 66.

Des modes de réalisation particuliers ont été décrits. Diverses variantes et modifications apparaîtront à l'homme de l'art. En outre, divers modes de réalisation avec diverses variantes ont été décrits ci-dessus. On note que divers éléments de ces divers modes de réalisation et variantes peuvent être combinés.

## Revendications

1. Dispositif optoélectronique (10 ; 55) comprenant :
un support (12) ;
au moins une première couche conductrice électriquement (18) recouvrant le support ;
des circuits de pixel d'affichage (Pix) comprenant des première et deuxième faces opposées (20, 22), fixés à la première couche conductrice électriquement, chaque circuit de pixel d'affichage comprenant un circuit électronique (30) comprenant la première face et une troisième face (32) opposée à la première face, la première face étant fixée à la première couche conductrice électriquement, et un circuit optoélectronique (40) fixé à la troisième face et comprenant au moins deux diodes électroluminescentes (LED), au moins l'une des électrodes de chaque diode électroluminescente étant connectée au circuit électronique par la troisième face, le circuit optoélectronique comprenant en outre des blocs photoluminescents (44) recouvrant les diodes électroluminescentes et des murs (46), conducteurs électriquement ou semiconducteurs, entourant les blocs photoluminescents ; et
au moins une deuxième couche conductrice électriquement (26) reliée électriquement à au moins l'un des circuits de pixel d'affichage.

2. Dispositif optoélectronique selon la revendication 1, dans lequel la deuxième couche conductrice électriquement (26) recouvre au moins partiellement ledit au moins l'un des circuits de pixel d'affichage (Pix).

3. Dispositif optoélectronique selon la revendication 2, dans lequel la deuxième couche conductrice électriquement (26) est reliée électriquement aux murs (46) dudit au moins l'un des circuits de pixel d'affichage.

4. Dispositif optoélectronique selon la revendication 1, dans lequel la deuxième couche conductrice électriquement (26) est, pour ledit au moins l'un des circuits de pixel d'affichage (Pix), au contact d'un plot conducteur électriquement (36) du circuit électronique (30) situé du côté de la troisième face (32).

5. Dispositif optoélectronique selon la revendication 1, dans lequel la deuxième couche conductrice électriquement (26) s'étend sur le support (12) et dans lequel la deuxième couche conductrice électriquement (26) est, pour ledit au moins l'un des circuits de pixel d'affichage (Pix), au contact d'un plot conducteur électriquement (98) du circuit électronique (30) situé du côté de la première face (20).

6. Dispositif optoélectronique selon l'une quelconque des revendications 1 à 4, comprenant en outre une première couche isolante électriquement (24) recouvrant la première couche conductrice électriquement (18) entre les circuits de pixel d'affichage (Pix) et interposée entre la première couche isolante électriquement et la deuxième couche conductrice électriquement (26) .

7. Dispositif optoélectronique selon l'une quelconque des revendications 1 à 6, comprenant en outre, pour chaque circuit de pixel d'affichage (Pix), une deuxième couche isolante électriquement (56) recouvrant les flancs du circuit de pixel d'affichage.

8. Dispositif optoélectronique selon l'une quelconque des revendications 1 à 7, dans lequel, pour chaque circuit de pixel d'affichage (Pix), le circuit optoélectronique (40) du circuit de pixel d'affichage comprend une première couche semiconductrice (54) sur laquelle reposent les murs (46) et les blocs photoluminescents (44) et, pour chaque diode électroluminescente, un empilement (41) reposant sur la première couche semiconductrice du côté opposé aux blocs photoluminescents et comprenant une deuxième couche semiconductrice (52) dopée d'un premier type de conductivité, une couche active (50) et une troisième couche semiconductrice (48) dopée d'un deuxième type de conductivité opposé au premier type de conductivité, les empilements étant distincts.

9. Dispositif optoélectronique selon la revendication 8, dans lequel chaque circuit de pixel d'affichage (Pix) comprend, pour chaque empilement (41), un plot conducteur (42) au contact de la première couche semiconductrice (54) et fixé au circuit électronique (30) du circuit de pixel d'affichage.

10. Dispositif optoélectronique selon l'une quelconque des revendications 1 à 9, comprenant au moins deux premières couches conductrices électriquement (62) disjointes et recouvrant le support (12), des circuits de pixel d'affichage (Pix) parmi les circuits de pixel d'affichage étant fixés à chaque première couche conductrice électriquement, le dispositif comprenant, en outre, au moins deux deuxièmes couches conductrices électriquement (66) chacune étant reliée électriquement à des circuits électroniques (30) parmi les circuits de pixel d'affichage.

11. Dispositif optoélectronique selon la revendication 10, dans lequel les deux premières couches conductrices électriquement (62) et les deux deuxièmes couches conductrices électriquement (66) ont la forme de bandes parallèles.

12. Procédé de fabrication d'un dispositif optoélectronique (10 ; 55) comprenant les étapes suivantes :
a) fabriquer des circuits de pixel d'affichage (Pix) comprenant des première et deuxième faces opposées (20, 22) et comprenant chacun un circuit électronique (30) comprenant la première face et une troisième face (32) opposée à la première face, et un circuit optoélectronique (40) fixé à la troisième face et comprenant au moins deux diodes électroluminescentes (LED), au moins l'une des électrodes de chaque diode électroluminescente étant connectée au circuit électronique par la troisième face, le circuit optoélectronique comprenant en outre des blocs photoluminescents (44) recouvrant les diodes électroluminescentes et des murs (26), conducteurs électriquement ou semiconducteurs, entourant les blocs photoluminescents ;
b) fabriquer un support (12) recouvert d'au moins une première couche conductrice électriquement (18) ;
c) fixer la première face du circuit électronique (20) de chaque circuit de pixel d'affichage à la première couche conductrice électriquement ; et
d) former au moins une deuxième couche conductrice électriquement (34) reliée électriquement à au moins l'un des circuits de pixel d'affichage.

13. Procédé selon la revendication 12, dans lequel la deuxième couche conductrice électriquement (26) recouvre au moins partiellement ledit au moins l'un des circuits de pixel d'affichage (Pix).

14. Procédé selon la revendication 13, dans lequel la deuxième couche conductrice électriquement (26) est reliée électriquement aux murs (46) dudit au moins l'un des circuits de pixel d'affichage.

15. Procédé selon la revendication 12, dans lequel la deuxième couche conductrice électriquement (26) est, pour ledit au moins l'un des circuits de pixel d'affichage (Pix), au contact d'un plot conducteur électriquement (36) du circuit électronique (30) situé du côté de la troisième face (32).

16. Procédé optoélectronique selon la revendication 13, dans lequel la deuxième couche conductrice électriquement (26) s'étend sur le support (12) et dans lequel la deuxième couche conductrice électriquement (26) est, pour ledit au moins l'un des circuits de pixel d'affichage (Pix), au contact d'un plot conducteur électriquement (98) du circuit électronique (30) situé du côté de la première face (20).

17. Procédé selon l'une quelconque des revendications 13 à 15, comprenant, entre les étapes c) et d), l'étape de formation d'une première couche isolante électriquement (24) recouvrant la première couche conductrice électriquement (18) entre les circuits de pixel d'affichage (Pix) et interposée entre la première couche isolante électriquement et la deuxième couche conductrice électriquement (26).

18. Procédé selon l'une quelconque des revendications 13 à 17, comprenant, avant l'étape c), l'étape de formation, pour chaque circuit de pixel d'affichage (Pix), en outre, d'une deuxième couche isolante électriquement (52) recouvrant les flancs du circuit de pixel d'affichage.

19. Procédé selon l'une quelconque des revendications 13 à 18, dans lequel l'étape a) comprend la formation, pour chaque diode électroluminescente (LED), d'un empilement (41) reposant sur une première couche semiconductrice (54) et comprenant une deuxième couche semiconductrice (52) dopée d'un premier type de conductivité, une couche active (50) et une troisième couche semiconductrice (48) dopée d'un deuxième type de conductivité opposé au premier type de conductivité, les empilements étant distincts.

## Patentansprüche

1. Optoelektronische Vorrichtung (10; 55), umfassend:
eine Halterung (12),
wenigstens eine erste elektrisch leitende Schicht (18), die die Halterung bedeckt,
Anzeigepixelschaltungen (Pix), die gegenüberliegende erste und zweite Flächen (20, 22) aufweisen, die mit der ersten elektrisch leitenden Schicht verbunden sind, wobei jede Anzeigepixelschaltung eine elektronische Schaltung (30), die die erste Fläche und eine der ersten Fläche gegenüberliegende dritte Fläche (32) aufweist, wobei die erste Fläche mit der ersten elektrisch leitenden Schicht verbunden ist, und eine optoelektronische Schaltung (40), die mit der dritten Fläche verbunden ist und wenigstens zwei Leuchtdioden (LEDs) aufweist, umfasst, wobei wenigstens eine der Elektroden jeder LED über die dritte Fläche mit der elektronischen Schaltung verbunden ist, wobei die optoelektronische Schaltung weiterhin nachleuchtende Blöcke (44), die die LEDs bedecken, und elektrisch leitende oder halbleitende Wände (46) um die nachleuchtenden Blöcke herum umfasst, und
wenigstens eine zweite elektrisch leitende Schicht (26), die elektrisch mit wenigstens einer der Anzeigepixelschaltungen gekoppelt ist.

2. Optoelektronische Vorrichtung nach Anspruch 1, wobei die zweite elektrisch leitende Schicht (26) wenigstens eine der Anzeigepixelschaltungen (Pix) wenigstens teilweise bedeckt.

3. Optoelektronische Vorrichtung nach Anspruch 2, wobei die zweite elektrisch leitende Schicht (26) elektrisch mit den Wänden (46) der wenigstens einen der Anzeigepixelschaltungen gekoppelt ist.

4. Optoelektronische Vorrichtung nach Anspruch 1, wobei die zweite elektrisch leitende Schicht (26), für wenigstens eine der Anzeigepixelschaltungen (Pix), in Kontakt mit einem elektrisch leitenden Pad (36) der elektronischen Schaltung (30) auf der Seite der dritten Fläche (32) ist.

5. Optoelektronische Vorrichtung nach Anspruch 1, wobei sich die zweite elektrisch leitende Schicht (26) auf der Halterung (12) erstreckt und wobei die zweite elektrisch leitende Schicht (26), für die wenigstens eine der Anzeigepixelschaltungen (Pix), in Kontakt mit einem elektrisch leitenden Pad (98) der elektronischen Schaltung (30) auf der Seite der ersten Fläche (20) ist.

6. Optoelektronische Vorrichtung nach einem der Ansprüche 1 bis 4, die weiterhin eine erste elektrisch isolierende Schicht (24) umfasst, die die erste elektrisch leitende Schicht (18) zwischen den Anzeigepixelschaltungen (Pix) bedeckt und zwischen der ersten elektrisch isolierenden Schicht und der zweiten elektrisch leitenden Schicht (26) angeordnet ist.

7. Optoelektronische Vorrichtung nach einem der Ansprüche 1 bis 6, die weiterhin, für jede Anzeigepixelschaltung (Pix), eine zweite elektrisch isolierende Schicht (56) umfasst, die die Seiten der Anzeigepixelschaltung bedeckt.

8. Optoelektronische Vorrichtung nach einem der Ansprüche 1 bis 7, wobei, für jede Anzeigepixelschaltung (Pix), die optoelektronische Schaltung (40) der Anzeigepixelschaltung eine erste Halbleiterschicht (54), die die Wände (46) und die nachleuchtenden Blöcke (54) hält, und, für jede LED, einen Stapel (41), der auf der ersten Halbleiterschicht auf der zu den nachleuchtenden Blöcken gegenüberliegenden Seite ruht und eine zweite dotierte Halbleiterschicht (52) eines ersten Leitfähigkeitstyps, eine aktive Schicht (50) und eine dritte dotierte Halbleiterschicht (48) eines zweiten Leitfähigkeitstyps, der dem ersten Leitfähigkeitstyp entgegengesetzt ist, aufweist, umfasst, wobei die Stapel distinkt sind.

9. Optoelektronische Vorrichtung nach Anspruch 8, wobei jede Anzeigepixelschaltung (Pix), für jeden Stapel (41), ein leitendes Pad (42) umfasst, das in Kontakt mit der ersten Halbleiterschicht (54) ist und mit der elektronischen Schaltung (30) der Anzeigepixelschaltung verbunden ist.

10. Optoelektronische Vorrichtung nach einem der Ansprüche 1 bis 9, die wenigstens zwei erste separate elektrisch leitende Schichten (62) umfasst, die die Halterung (12) bedecken, wobei die Anzeigepixelschaltungen (Pix) innerhalb der Anzeigepixelschaltungen mit jeder ersten elektrisch leitenden Schicht verbunden sind, wobei die Vorrichtung weiterhin wenigstens zwei elektrisch leitende Schichten (66) umfasst, die jeweils elektrisch mit elektronischen Schaltungen (30) innerhalb der Anzeigepixelschaltungen gekoppelt sind.

11. Optoelektronische Vorrichtung nach Anspruch 10, wobei die ersten zwei elektrisch leitenden Schichten (62) und die zweiten zwei elektrisch leitenden Schichten (66) die Form von parallelen Streifen aufweisen.

12. Verfahren zum Herstellen einer optoelektronischen Vorrichtung (10; 55), das die folgenden Schritte umfasst:
a) Herstellen von Anzeigepixelschaltungen (Pix), die gegenüberliegende erste und zweite Flächen (20, 22) aufweisen und jeweils eine elektronische Schaltung (30), die die erste Fläche und eine der ersten Fläche gegenüberliegende dritte Fläche (32) aufweist, und eine optoelektronische Schaltung (40), die mit der dritten Fläche verbunden ist und wenigstens zwei Leuchtdioden (LEDs) aufweist, umfasst, wobei wenigstens eine der Elektroden jeder LED über die dritte Fläche mit der elektronischen Schaltung verbunden ist, wobei die optoelektronische Schaltung weiterhin nachleuchtende Blöcke (44), die die LEDs bedecken, und elektrisch leitende oder halbleitende Wände (26) um die nachleuchtenden Blöcke herum umfasst, und
b) Herstellen einer Halterung (12), die durch wenigstens eine erste elektrisch leitende Schicht (18) bedeckt ist,
c) Verbinden der ersten Fläche der elektronischen Schaltung (20) jeder Anzeigepixelschaltung mit der ersten elektrisch leitenden Schicht, und
d) Ausbilden wenigstens einer zweiten elektrisch leitenden Schicht (34), die elektrisch mit wenigstens einer der Anzeigepixelschaltungen gekoppelt ist.

13. Verfahren nach Anspruch 12, wobei die zweite elektrisch leitende Schicht (26) die wenigstens eine der Anzeigepixelschaltungen (Pix) wenigstens teilweise bedeckt.

14. Verfahren nach Anspruch 13, wobei die zweite elektrisch leitende Schicht (26) elektrisch mit den Wänden (46) der wenigstens einen der Anzeigepixelschaltungen gekoppelt ist.

15. Verfahren nach Anspruch 12, wobei die zweite elektrisch leitende Schicht (26), für die wenigstens eine der Anzeigepixelschaltungen (Pix), in Kontakt mit einem elektrisch leitenden Pad (36) der elektronischen Schaltung (30) auf der Seite der dritten Fläche (32) ist.

16. Verfahren nach Anspruch 13, wobei sich die zweite elektrisch leitende Schicht (26) auf der Halteschicht (12) erstreckt und wobei die zweite elektrisch leitende Schicht (26), für die wenigstens eine der Anzeigepixelschaltungen (Pix), in Kontakt mit einem elektrischen leitenden Pad (98) der elektronischen Schaltung (30) auf der Seite der ersten Fläche (20) ist.

17. Verfahren nach einem der Ansprüche 13 bis 15, das zwischen den Schritten c) und d) einen Schritt zum Ausbilden einer ersten elektrisch isolierenden Schicht (24) umfasst, die die erste elektrisch leitende Schicht (18) zwischen den Anzeigepixelschaltungen (Pix) bedeckt und zwischen der ersten elektrisch isolierenden Schicht und der zweiten elektrisch isolierenden Schicht (26) angeordnet ist.

18. Verfahren nach einem der Ansprüche 13 bis 17, das vor dem Schritt c) einen Schritt zum Ausbilden, für jede Anzeigepixelschaltung (Pix), weiterhin einer zweiten elektrisch isolierenden Schicht (52), die die Seiten der Anzeigepixelschaltung bedeckt, umfasst.

19. Verfahren nach einem der Ansprüche 13 bis 18, wobei der Schritt a) weiterhin das Ausbilden, für jede Leuchtdiode (LED), eines Stapels (41), der auf einer ersten Halbleiterschicht (54) ruht und eine zweite dotierte Halbleiterschicht (52) eines ersten Leitfähigkeitstyps, eine aktive Schicht (50) und eine dritte dotierte Halbleiterschicht (48) eines zweiten Leitfähigkeitstyps, der dem ersten Leitfähigkeitstyp entgegengesetzt ist, aufweist, umfasst, wobei die Stapel distinkt sind.

## Claims

1. An optoelectronic device (10; 55) comprising:
a support (12);
at least one first electrically-conductive layer (18) covering the support;
display pixel circuits (Pix) comprising first and second opposite surfaces (20, 22) bonded to the first electrically-conductive layer, each display pixel circuit comprising an electronic circuit (30) comprising the first surface and a third surface (32) opposite to the first surface, the first surface being bonded to the first electrically-conductive layer, and an optoelectronic circuit (40) bonded to the third surface and comprising at least two light-emitting diodes (LED), at least one of the electrodes of each light-emitting diode being connected to the electronic circuit by the third surface, the optoelectronic circuit further comprising photoluminescent blocks (44) covering the light-emitting diodes and electrically-conductive or semiconductor walls (46) surrounding the photoluminescent blocks; and
at least one second electrically-conductive layer (26) electrically coupled to at least one of the display pixel circuits.

2. The optoelectronic device of claim 1, wherein the second electrically-conductive layer (26) at least partially covers said at least one of the display pixel circuits (Pix).

3. The optoelectronic device of claim 2, wherein the second electrically-conductive layer (26) is electrically coupled to the walls (46) of said at least one of the display pixel circuits.

4. The optoelectronic device of claim 1, wherein the second electrically-conductive layer (26) is, for at least one of the display pixel circuits (Pix), in contact with an electrically-conductive pad (36) of the electronic circuit (30) located on the side of the third surface (32).

5. The optoelectronic device of claim 1, wherein the second electrically-conductive layer (26) extends on the support (12) and wherein the second electrically-conductive layer (26) is, for said at least one of the display pixel circuits (Pix), in contact with an electrically-conductive pad (98) of the electronic circuit (30) located on the side of the first surface (20).

6. The optoelectronic device of any of claims 1 to 4, further comprising a first electrically-insulating layer (24) covering the first electrically-conductive layer (18) between the display pixel circuits (Pix) and interposed between the first electrically-insulating layer and the second electrically-conductive layer (26).

7. The optoelectronic device of any of claims 1 to 6, further comprising, for each display pixel circuit (Pix), a second electrically-insulating layer (56) covering the sides of the display pixel circuit.

8. The optoelectronic device of any of claims 1 to 7, wherein, for each display pixel circuit (Pix), the optoelectronic circuit (40) of the display pixel circuit comprises a first semiconductor layer (54) supporting the walls (46) and the photoluminescent blocks (44) and, for each light-emitting diode, a stack (41) resting on the first semiconductor layer on the side opposite to the photoluminescent blocks and comprising a second doped semiconductor layer (52) of a first conductivity type, an active layer (50), and a third doped semiconductor layer (48) of a second conductivity type opposite to the first conductivity type, the stacks being distinct.

9. The optoelectronic device of claim 8, wherein each display pixel circuit (Pix) comprises, for each stack (41), a conductive pad (42) in contact with the first semiconductor layer (54) and bonded to the electronic circuit (30) of the display pixel circuit.

10. The optoelectronic device of any of claims 1 to 9, comprising at least two first separate electrically-conductive layers (62) covering the support (12), display pixel circuits (Pix) among the display pixel circuits being bonded to each first electrically-conductive layer, the device further comprising at least two second electrically-conductive layers (66), each being electrically coupled to electronic circuits (30) among the display pixel circuits.

11. The optoelectronic device of claim 10, wherein the first two electrically-conductive layers (62) and the second two electrically-conductive layers (66) have the shape of parallel strips.

12. A method of manufacturing an optoelectronic device (10; 55), comprising the steps of:
a) manufacturing display pixel circuits (Pix) comprising first and second opposite surfaces (20, 22) and each comprising an electronic circuit (30) comprising the first surface and a third surface (32) opposite to the first surface, and an optoelectronic circuit (40) bonded to the third surface and comprising at least two light-emitting diodes (LED), at least one of the electrodes of each light-emitting diode being connected to the electronic circuit by the third surface, the optoelectronic circuit further comprising photoluminescent blocks (44) covering the light-emitting diodes and electrically-conductive or semiconductor walls (26) surrounding the photoluminescent blocks;
b) manufacturing a support (12) covered with at least one first electrically-conductive layer (18);
c) bonding the first surface of the electronic circuit (20) of each display pixel circuit to the first electrically-conductive layer; and
d) forming at least one second electrically-conductive layer (34) electrically coupled to at least one of the display pixel circuits.

13. The method of claim 12, wherein the second electrically-conductive layer (26) at least partially covers said at least one of the display pixel circuits (Pix).

14. The method of claim 13, wherein the second electrically-conductive layer (26) is electrically coupled to the walls (46) of said at least one of the display pixel circuits.

15. The method of claim 12, wherein the second electrically-conductive layer (26) is, for said at least one of the display pixel circuits (Pix), in contact with an electrically-conductive pad (36) of the electronic circuit (30) located on the side of the third surface (32).

16. The optoelectronic method of claim 13, wherein the second electrically-conductive layer (26) extends on the support (12) and wherein the second electrically-conductive layer (26) is, for said at least one of the display pixel circuits (Pix), in contact with an electrically-conductive pad (98) of the electronic circuit (30) located on the side of the first surface (20).

17. The method of any of claims 13 to 15, comprising, between steps c) and d), the step of forming a first electrically-insulating layer (24) covering the first electrically-conductive layer (18) between the display pixel circuits (Pix) and interposed between the first electrically-insulating layer and the second electrically-conductive layer (26).

18. The method of any of claims 13 to 17, comprising, before step c) , the step of forming, for each display pixel circuit (Pix), further, a second electrically-insulating layer (52) covering the sides of the display pixel circuit.

19. The method of any of claims 13 to 18, wherein step a) comprises forming, for each light-emitting diode (LED), a stack (41) resting on a first semiconductor layer (54) and comprising a second doped semiconductor layer (52) of a first conductive type, an active layer (50), and a third doped semiconductor layer (48) of a second conductivity type opposite to the first conductivity type, the stacks being distinct.
